## Europäisches Patentamt
## European Patent Office
## Office européen des brevets

(19)

(11) Veröffentlichungsnummer: **0 168 793**
**B1**

(12) **EUROPÄISCHE PATENTSCHRIFT**

(45) Veröffentlichungstag der Patentschrift: **17.10.90**

(21) Anmeldenummer: **85108763.5**

(22) Anmeldetag: **12.07.85**

(51) Int. Cl.⁵: **H 03 M 13/22, G 11 B 20/18**

(54) **Verfahren und Vorrichtung zum Decodieren.**

(30) Priorität: **18.07.84 CH 3508/84**

(43) Veröffentlichungstag der Anmeldung:
**22.01.86 Patentblatt 86/04**

(45) Bekanntmachung des Hinweises auf die
Patenterteilung:
**17.10.90 Patentblatt 90/42**

(84) Benannte Vertragsstaaten:
**AT BE CH DE FR GB IT LI NL SE**

(56) Entgegenhaltungen:
EP-A-0 074 644    GB-A-2 082 809
EP-A-0 076 862    GB-A-2 082 828
EP-A-0 094 671    GB-A-2 084 363
DE-A-3 246 254    GB-A-2 107 496

PATENTS ABSTRACTS OF JAPAN, Band 6, Nr.
144 (E-122) 1022r, 3. August 1982; & JP - A - 57
65 937 (MATSUSHITA DENKI SANGYO K.K.)
21-04-1982

(73) Patentinhaber: **WILLI STUDER AG Fabrik für
elektronische Apparate
Althardstrasse 30
CH-8105 Regensdorf ZH (CH)**

(72) Erfinder: **Brandes, Claudia
Schulhausstrasse 22
CH-8153 Rümlang ZH (CH)**

Courier Press, Leamington Spa, England.

# EP 0 168 793 B1

**Beschreibung**

Die Erfindung betrifft ein Verfahren und eine Vorrichtung zum Decodieren einer ersten Folge von digitalen Datenwoertern und Korrekturwoertern, die in einer ersten Reihenfolge auftreten, wobei die Datenwoerter und Korrekturwoerter dieser ersten Folge so neu kombiniert werden, dass eine zweite Folge mit einer zweiten Reihenfolge der Datenwoerter und Korrekturwoerter entsteht, wobei die erste Folge in Bloecke eingeteilt ist, die mehrere Datenwoerter und mehrere Korrekturwoerter in der ersten Reihenfolge angeordnet enthalten.

Solche Verfahren und Vorrichtungen werden insbesondere bei der Wiedergabe von digital aufgezeichneten Audio-Signalen von einem Aufzeichnungstraeger angewendet. Ueblicherweise werden natuerlicherweise analog vorhandene Signale fuer deren Speicherung auf einem Aufzeichnungstraeger digitalisiert. Das bedeutet, dass dann das Signal aus einer Folge von Datenwoertern besteht, von denen jedes einen Abtastwert z.B. einen Spannungswert des urspruenglichen analogen Signales darstellt. Um die aufgezeichneten Datenwoerter zu schuetzen, d.h. um zu verhindern dass diese Datenwoerter veraendert werden oder um zu verhindern, dass gleich mehrere aufeinanderfolgende Datenwoerter auf einmal verschwinden, wird die Folge der Datenwoerter vor der Aufzeichnung in an sich bekannter Weise codiert. Bei der Codierung wird die urspruengliche Folge der Datenwoerter gemaess einem Code zerstoert und es werden zusaetzliche Korrekturwoerter beigegeben. Die Reihenfolge der Datenwoerter ist dabei so veraendert, dass urspruenglich aufeinanderfolgende Datenwoerter voneinander getrennt sind und dass andere Datenwoerter dazwischen eingeschoben sind. Die Korrekturwoerter ermoeglichen es in einer Gruppe von Datenwoertern eines oder mehrere davon zu korrigieren und somit zu erhalten. Die Codierung der Datenwoerter ermoeglicht den Schutz vor Beeintraechtigungen der Aufzeichnungen durch Staub, Beschaedigung des Aufzeichnungstraegers, Schnitt bei bandfoermigem Aufzeichnungstraeger, Ueberspielen usw. Fuer die Wiedergabe der aufgezeichneten Datenwoerter muessen diese gemaess demselben Code wieder decodiert werden. Beim Decodieren wird die urspruengliche Reihenfolge der Datenwoerter wieder hergestellt. Dabei wird versucht, durch moeglichst geschicktes Ausnutzen der, der Aufzeichnung beim Codieren beigefuegten, Korrekturwoerter den genannten Beeintraechtigungen entgegenzuwirken, so dass das urspruengliche digitale Signal moeglichst fehlerfrei wiedergegeben wird.

Solche Decodierverfahren sind aus den Audio Engineering Society Preprints vom 31. Oktober 1980 (Nr. 1677) und vom 2. Maerz (Nr. 1885) bereits bekannt. Dabei werden bei der Codierung die einzelnen Datenwoerter, die beispielsweise je einen Abtastwert eines Audiosignales darstellen, gespreizt, mit Paritaetscodewoertern und einer Blockcodierung ergaenzt und zu Bloecken zusammengefasst. Im Falle des bekannten DASH-Formates bedeutet dies, dass je zwoelf Datenwoertern vier Korrekturwoerter (je zwei Q-, P-Paritaetscodewoerter) und ein Blockfehlererkennungswort beigegeben werden.

Aus den folgenden Veroeffentlichungen sind auch Verfahren zum Speichern, Uebertragen und Verschachteln (Spreizen) von digitalen Daten bekannt.

Aus der DE—A—3 246 254 ist ein Verfahren zur Adressierung von Speichern bekannt, das das Schreiben von Daten in einen Speicher erleichtert, indem die Adressen in Reihenadressen und Spaltenadressen aufgeteilt werden. Dadurch kann die Ausnutzung eines Speichers fuer das Codieren und Decodieren verbessert werden. Damit koennen Speicher geringerer Kapazitaet verwendet werden. Aber mit diesem Verfahren kann man nicht eine groessere Anzahl aufeinanderfolgender fehlerhafter Datenwoerter, unter Ausnutzung der vorhandenen Korrekturwoerter, durch richtige Datenwoerter ersetzen als dies bisher schon bekannt war.

Aus der EP—A—0 094 671 ist ein Verfahren zur Uebertragung von Daten in digitaler Form bekannt. Es betrifft insbesondere die Uebertragung von digitalen Audio-Signalen, die neben einer bestimmten Anzahl Datenwoerter auch zwei Paritaetswoerter in einem Block aufweisen. Um die Moeglichkeit, fehlerhafte Datenwoerter korrigieren zu koennen, zu steigern, soll gemaess diesem Verfahren eines der Paritaetswoerter an einem Ende und das andere Paritaetswort in der Mitte eines Blockes angeordnet werden.

Aus PATENT ABSTRACTS OF JAPAN, Band 6, Nr. 144 (E—122) (1022), entsprechend JP—A—57 65 937 ist ein Verfahren zum Verschachteln aufeinanderfolgender digitaler Datenwoerter in einem Speicher bekannt. Um die Faehigkeit fehlerhafte Datenwoerter korrigieren zu koennen, zu erhoehen, werden in jedem Block, der neben den Datenwoertern auch P-und Q-Paritaetswoerter erhalten hat, die P- und Q-Paritaetswoerter in kleinen Bloecken so aufgeteilt, dass die Abstaende zwischen P-Paritaetswoertern verkuerzt sind. Damit laesst sich das Verfahren auch in relativ kleinen Speichern durchfuehren.

Beim Decodieren oder Entschachteln mit den bekannten Verfahren sind somit folgende drei Verfahrenschritte ueblich:

1. Auswerten des Blockfehlererkennungscodes,
2. Auswerten des ersten Korrekturcodes und
3. Auswerten des zweiten Korrekturcodes.

Die Auswertung eines jeweils vorausgehenden Codes ergibt Fehleranzeigen und erlaubt es bei der Auswertung des nachfolgenden Codes den Fehler zu beheben. Somit kann der erste und der zweite Korrekturcode zur Behebung von Fehlern dienen. Durch wiederholtes Auswerten des ersten und es zweiten Korrekturcodes laesst sich die Korrekturfaehigkeit des Verfahrens oder der Vorrichtung weiter verbessern.

## EP 0 168 793 B1

Doch die Wirkung weiterer Korrekturschritte bleibt beschraenkt. Wiederholtes Auswerten des ersten und des zweiten Korrekturcodes braucht aber auch Zeit, die oft gar nicht zur Verfuegung steht.

Die Erfindung, wie sie in den Anspruechen gekennzeichnet ist, loest die Aufgabe, ein Verfahren und eine Vorrichtung zu schaffen, mit denen ohne zusaetzliche Verfahrensschritte eine groessere Anzahl aufeinanderfolgender fehlerhafter Bloecke korrigiert werden kann.

Die erfindungsgemaessen Vorteile ergeben sich daraus, dass zwei verschiedene Gruppen ($Q_0$ und $P_0$) von Datenwoertern und Korrekturwoertern in einem ersten Schritt gleichzeitig oder parallel einer Pruefoperation und anschliessend in einem zweiten Schritt ebenfalls gleichzeitig einer Auswertungsoperation unterzogen werden, sowie aus der besonderen Zusammensetzung der beiden Gruppen von Daten- und Korrekturwoertern. Dies im Gegensatz zu der ueblichen Folge von Schritten mit denen eine erste Gruppe zuerst geprueft, dann ausgewertet und nachfolgend eine zweite Gruppe wieder zuerst geprueft und dann ausgewertet wird, was vier Schritte benoetigt. Um dies zu ermoeglichen ist die erfindungsgemaesse Vorrichtung mit einer Zuordnungsschaltung fuer Blockmarkierungen und Wortmarkierungen versehen, die es erlaubt, Blockmarkierungen und Wortmarkierungen unabhaengig voneinander zu veraendern. So koennen in einer Wortgruppe mehrere fehlerhafte Datenwoerter korrigiert werden.

Weitere durch die Erfindung erreichte Vorteile sind insbesondere darin zu sehen, dass beispielsweise beim Ueberschreiben neuer Aufzeichnungen ueber alte Aufzeichnungen mit kurzzeitig fehlerhafter Ueberschreibung kurze Zonen mit Fremdsignalen entstehen, die gemaess der Erfindung in der gleichen Art wie herkoemmliche Lesefehler sehr gut korrigiert werden koennen. Auf einen Loeschkopf in einem digital arbeitenden Magnetbandgeraet kann somit verzichtet werden. Bei gruppenweise auftretenden Lesefehlern (Bursterror) kann die Korrekturfaehigkeit des Decodierers bei einer vertretbaren Anzahl von Korrekturschritten dank der Erfindung stark erweitert werden.

Bei bandfoermigen Aufzeichnungstraegern, die durch einen Schnitt getrennt und neu zusammengesetzt werden, treten in der Umgebung des Schnittes auf verschiedenen Spuren nicht zusammengehoerende Datensignale auf, die faelschlicherweise als Schreibfehler aufgefasst werden koennten. Die Erfindung erlaubt es, Fehler bei Bandschnitten von Einzelschreibfehlern auf einzelnen Spuren zuverlaessig zu unterscheiden und eine akustisch geeignete Verarbeitung der Signale bei der Schnittstelle zu gewaehrleisten.

Im folgenden wird die Erfindung anhand von lediglich einen Ausführungsweg darstellenden Zeichnungen näher erläutert. Es zeigt

Figur 1 in schematischer Darstellung einen Block mit Datenwörtern und Korrekturwörtern,

Figur 2 bis 5 in schematischer Darstellung Teile eines Speichers für Daten- und Korrekturwörter,

Figur 6, 7a und b in vergrösserter schematischer Darstellung Teile eines Speichers für Daten- und Korrekturwörter,

Figur 8 eine tabellarische Uebersicht über die Möglichkeiten zur Fehlerkorrektur,

Figur 9 eine schematische Uebersicht über eine Vorrichtung zum Kombinieren und Rekombinieren anfallender zusammengehörender Datenwörter und

Figur 10, 11, 12 und 13 Teile der Vorrichtung gemäss Figur 9.

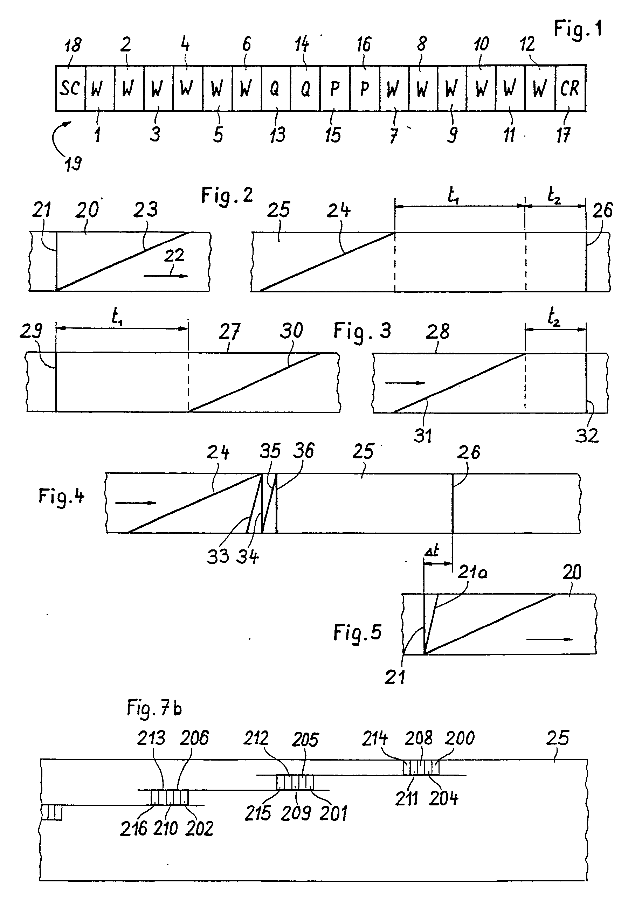

Figur 1 zeigt einen Block 19, bestehend der Reihe nach von links nach rechts in bekannter Weise aus einem Synchronisationswort 18, einer ersten Gruppe von Datenwörtern (W) 1, 2, 3, 4, 5 und 6, einem Paar Q-Korrekturwörter 13 und 14, einem Paar P-Korrekturwörter 15 und 16, einer zweiten Gruppe von Datenwörtern (W) 7, 8, 9, 10, 11 und 12 sowie einem Blockfehlererkennungscode (CR für CRCC = cyclic redundancy check code) 17. Beispielsweise weisen alle diese Worte 16-Bit Wortlänge auf wie dies aus dem DASH-Format allgemein bekannt ist.

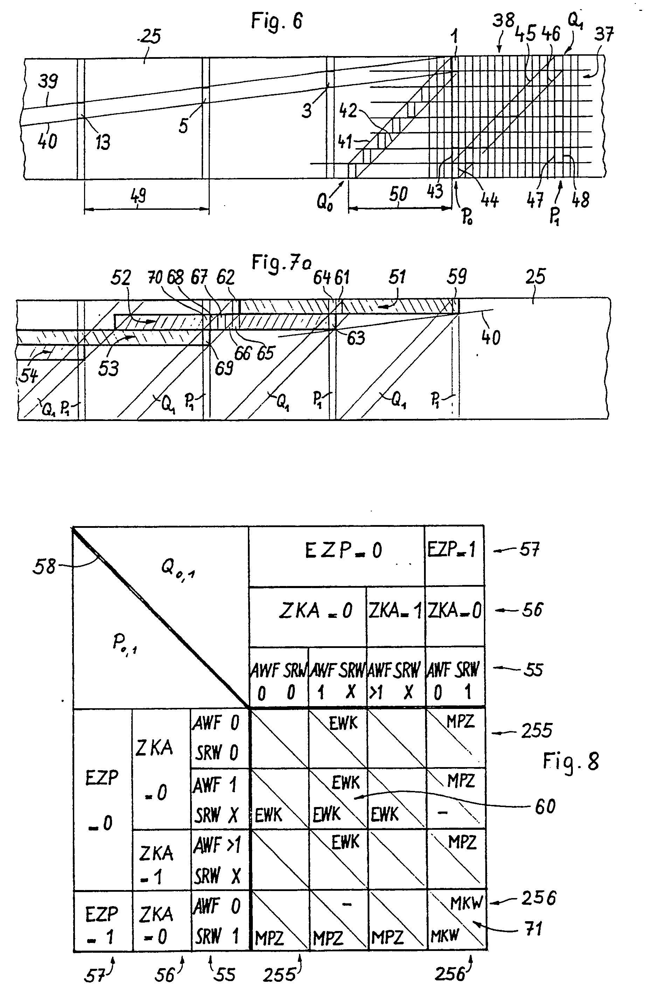

Figur 2 zeigt Teile 20 und 25 eines Speichers, der eine Spalten- und Zeilenstruktur aufweist, wie auch in Fig. 6 gezeigt. Die einzelnen Speicherplätze werden in bekannter Weise durch Adressen angesteuert, und zwar so, dass Ort und Zeit als Bezugsgrössen für Speicherplätze äquivalente Begriffe darstellen. Zum Codieren und Decodieren ist eine Aufteilung in geradzahlige und ungeradzahlige Datenwörter üblich und auch in diesem Beispiel vorausgesetzt.

Die linke Seite von Figur 2 mit dem Teil 20 zeigt deshalb einen Codierer, in dem zusammengehörende ungeradzahlige Datenwörter in Speicherplätzen längs einer Linie 21 eingelesen werden. Beim Einlesen werden den Datenwörtern auch zwei Korrekturwörter beigegeben. Die zeitliche bzw. örtliche Orientierung wird durch einen Pfeil 22 angegeben.

Von einem bestimmten Zeitpunkt an werden beispielsweise nicht zusammengehörende ungeradzahlige Daten- und Korrekturwörter 1 bis 15, die Speicherplätze längs einer Ausleselinie 23 belegen aus dem Speicher ausgelesen.

Das bedeutet, dass jedes der Daten- und Korrekturwörter 1, 3, 5, 7, 9, 11, 13 und 15, eine gewisse zeitliche Verzögerung zu seinem Nachbarn erfahren hat. Das Ein- und das Auslesen erfolgt dabei in bekannter Weise durch Steuerung durch einen Adressgenerator 141.

Figur 2 rechte Seite zeigt den Teil 25 des Speichers zur Rekombination oder Decodierung der längs einer schrägen Einleselinie 24 anfallenden Daten- und Korrekturwörter. Das Auslesen erfolgt wiederum parallel zu den Spalten zu einem Zeitpunkt, der durch die Lage einer Ausleselinie 26 gegeben ist. Die ungeradzahligen Daten- und Korrekturwörter erfahren im Teil 25 des Speichers weitere zeitliche Verzögerungen um Zeiten $t_1$ und $t_2$.

Figur 3 zeigt weitere Teile 27 und 28 des Speichers, welche den Teilen 20 und 25 gemäss Figur 2 entsprechen. In den Teilen 27 und 28 werden geradzahlige Datenwörter codiert und decodiert.

Nach dem gleichzeitigen Einlesen längs einer Einleselinie 29 erfolgt eine zeitliche Verzögerung um eine Zeit $t_1$ bis zum Beginn des zeitlich gestaffelten Auslesens längs einer schrägen Ausleselinie 30.

Das Decodieren erfolgt wiederum zwischen dem Einlesen der Daten- und Korrekturwörter längs einer Einleselinie 31 und dem Auslesen der Datenwörter längs einer Ausleselinie 32 nach zusätzlicher Verzögerung um die Zeit $t_2$.

Figur 4 zeigt nochmals den Teil 25 des Speichers gemäss Figur 2. Darin sind zusätzliche Prüflinien 33, 34, 35 und 36 eingezeichnet längs denen Wortgruppen angeordnet sind, die Prüf- und Auswerteoperationen unterzogen werden. Diese können während der Zeit $t_2$ stattfinden.

Figur 5 zeigt nochmals den Teil 20 des Speichers gemäss Figur 2. Darin sind die Linien 21, 21a für die Berechnung von P- und Q-Korrekturwörtern eingezeichnet.

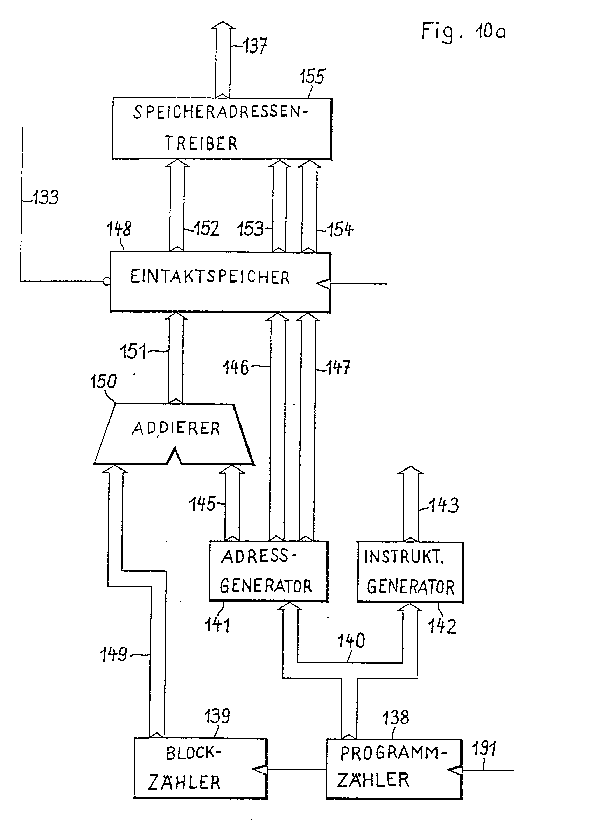

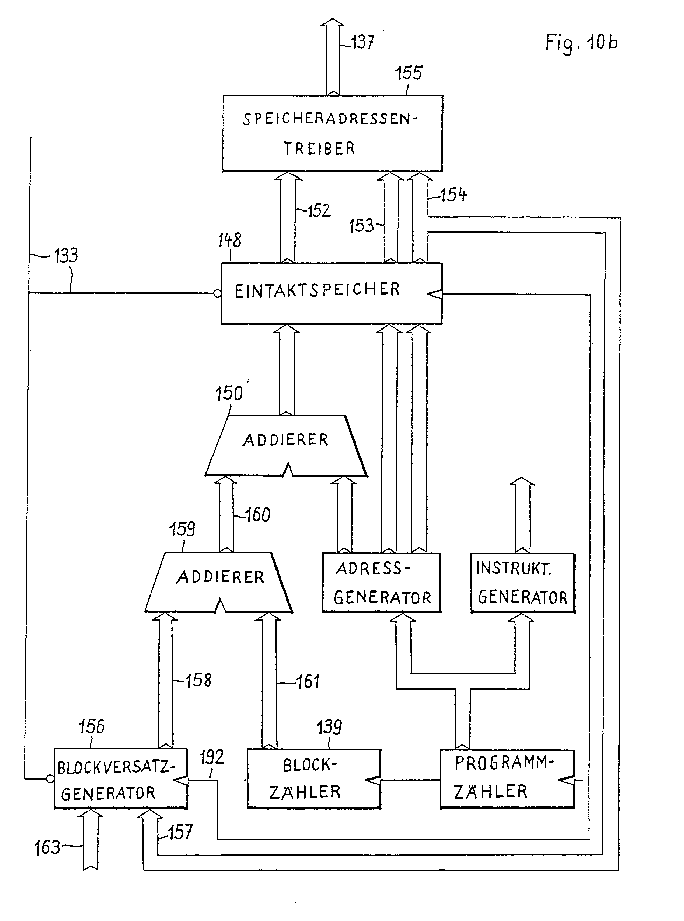

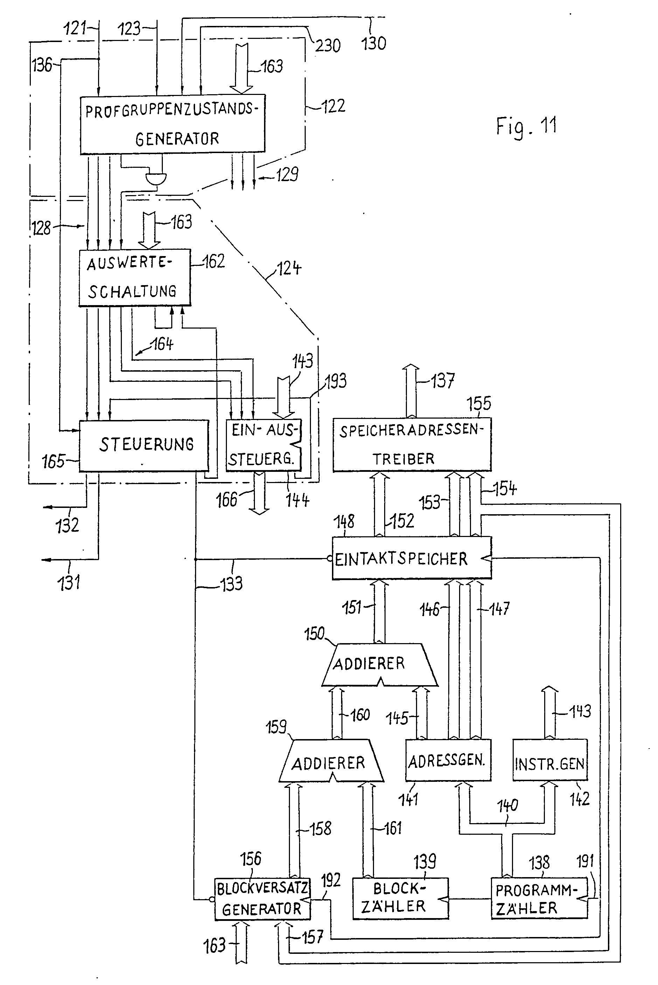

Die Figuren 4 und 5 zeigen die relative Lage der Einleselinie 21 des Codierers für ungeradzahlige Datenwörter und der Ausleselinie 26 des Decodierers für ungeradzahlige Datenwörter. Das bedeutet, dass im Adressgenerator 141 (Fig. 10, 11) die Einleseadressen für den Codierer und die Ausleseadressen für den Decodierer um die Zeit $\triangle t$ versetzt sind.

Figur 6 zeigt einen Ausschnitt des Teils 25 des Speichers, entsprechend Figur 4. Dabei ist die Struktur des Speichers aus Zeilen 37 und Spalten 38 besser ersichtlich. Der Teil 25 des Speichers weist zum Decodieren der acht ungeradzahligen Daten- und Korrekturwörter des Blockes 19 entsprechend acht Zeilen 37 auf. Die Anzahl der Spalten 38 richtet sich nach dem Zeitbedarf für das Einlesen und die Verzögerungen $t_1$ und $t_2$. Längs der Einleselinien 39, 40 werden Daten- und Korrekturwörter eingelesen. Am Beispiel des Blockes 19 gezeigt, erkennt man längs der Einleselinien 39, 40 die Datenworte 1, 3 und 5 sowie das Q-Korrekturwort 13. Die übrigen ungeradzahligen Daten- und Korrekturwörter befinden sich ebenfalls längs der Einleselinien 39, 40, aber ausserhalb des Bildbereiches von Figur 6. Erste Linien 41 und 42 definieren eine erste Wortgruppe ($Q_0$) mit sechs Datenwörtern und je einem P- und Q-Korrekturwort aus verschiedenen zeitlich aufeinanderfolgenden Blöcken.

Längs zweiter Linien 43 und 44, die mit einer Spalte 38 zusammenfallen, ist eine zweite Wortgruppe ($P_0$) mit sechs Datenwörtern angeordnet. Dritte Linien 45 und 46 parallel zu den ersten Linien 41, 42 definieren eine dritte Wortgruppe ($Q_1$) und vierte Linien 47 und 48, parallel zu den zweiten Linien 43, 44 definieren eine vierte Wortgruppe ($P_1$).

Längs der Einleselinien 39, 40 weisen Daten- und Korrekturwörter des Blockes 19 (Fig. 1) einen Spreizabstand 49 auf. Die Zeit, die diesem Spreizabstand 49 entspricht, ist grösser als die Zeit die einer Länge 50 der ersten und dritten Wortgruppe ($Q_0$ und $Q_1$) entspricht. Dabei gehören Daten- und Korrekturwörter des Blockes 19 zu einer ersten Folge digitaler Daten- und Korrekturwörter in einer ersten Ordnung und Daten- und Korrekturwörter der P-Wortgruppen gehören zu einer zweiten Folge mit Daten- und Korrekturwörtern in einer zweiten Ordnung. Die erste und die zweite Wortgruppe ($Q_0$ und $P_0$) und der Block 19 längs der Einleselinie 39, 40 treffen sich im Datenwort 1 des Blockes 19. Die dritte Wortgruppe ($Q_1$) trifft die zweite Wortgruppe ($P_0$) in deren letztem und die vierte Wortgruppe ($P_1$) in deren erstem Datenwort.

Figur 7a zeigt den Teil 25 des Speichers analog zu Figur 6. Darin erkennt man wiederum die Einleselinie 40. Weiter erkennt man drei Gruppen 51, 52 und 53 von Datenwörtern sowie teilweise eine Gruppe 54 von Korrekturwörtern. Diese Gruppen 51, 52, 53, 54 umfassen in diesem Beispiel je 30 Datenwörter oder Korrekturwörter. Je das erste Daten- und Korrekturwort 59, 63, 69 usw. aus jeder Gruppe 51, 52, 53 und 54 usw. bilden zusammen einen Block 19 von Daten- und Korrekturwörtern. Je das zweite Daten- und Korrekturwort aus jeder Gruppe 51, 52, 53 und 54 bilden zusammen wiederum einen Block 19 von Daten- und Korrekturwörtern usw. Weiter sind verschiedene $Q_1$- und $P_1$-Prüfgruppen zu verschiedenen Zeitpunkten eingezeichnet. Figur 7b zeigt denselben Teil 25 des Speichers in dem Datenwörter 200 bis 216 speziell hervorgehoben sind.

Figur 8 zeigt eine tabellarische Uebersicht, die die Beziehungen zwischen auftretenden Fehlermustern, Korrekturmöglichkeiten entsprechend den auftretenden Fehlermustern und der Codierung der auftretenden Fehlermuster mit logischen Variablen wie sie für die Verarbeitung verwendet wird, zeigt.

Beschränkt man seine Betrachtungen zuerst auf die beiden Zeilen 55 und 255, so gibt die Zeile 55 den Fehlerzustand in einer Q- oder P-Wortgruppe, die Zeile 255, die aus dem Fehlerzustand abzuleitende Auswertung an. Die Prüfung besteht darin, dass die Anzahl der fehlerhaften Datenwörter m einer Wortgruppe in bekannter Weise ermittelt wird (was ein AWF-Signal ergibt), und dass die Paritätssumme aller fehlerfreien Datenwörter aus der Wortgruppe auf den Wert Null geprüft wird (was ein Signal SRW ergibt).

Die Zeilen 56 und 57 in Figur 8 stellen die Umcodierung der Fehlermuster (durch AWF und SRW gekennzeichnet) für die weitere Verarbeitung der Fehlersignale dar, wobei ZKA bedeutet, dass eine Wortgruppe zuviele Wortfehler enthält und EZP bedeutet, dass eine Wortgruppe nicht zusammengehörende Datenwörter enthält, derart, dass ihre Summe von Null abweicht.

EP 0 168 793 B1

Dabei bedeutet:

AWF = Ø,      dass die Auswertung des Blockfehlererkennungscodes 17 für einen Block 19 für *keines* der Daten und Korrekturwörter aus der Wortgruppe und somit der beteiligten Blöcke 19 einen Fehler ergeben hat.

AWF = 1,      dass die Auswertung für *eines* der Daten- und Korrekturdwörter aus der Wortgruppe un somit der beteiligten Blöcke 19 einen Fehler ergeben hat.

AWF > 1,      dass die Auswertung für *mehrere* der Daten- und Korrekturwörter aus der Wortgruppe und somit der beteiligten Blöcke 19 einen Fehler ergaben hat.

SRW = Ø,      dass die (modulo −2) Summe aller fehlerhaften Daten- und Korrekturwörter der Wortgruppe den Wert *gleich* Null ergibt.

SRW = 1,      dass die genannte Summe einen Wert *ungleich* Null ergibt.

ZKA = Ø,      dass die Wortgruppe höchstens einen, durch den Blockfehlererkennungscode erkannten, Fehler enthält, und dass die (modulo −2) Summe aller fehlerfreien Daten- und Korrekturwörter in diesem Fall gerade den Wert des fehlerhaften Daten- *oder* Korrekturwortes darstellt und der Fehler somit korrigiert werden kann.

ZKA = 1,      dass die Wortgruppe mehr als einen Fehler enthält und somit nichts korrigiert werden kann.

EZP = Ø,      dass die (modulo −2) Summe aller fehlerfreien Daten- und Korrekturwörter der Wortgruppe den Wert Null ergibt, und dass gar keine Fehler aufgetreten sind, die durch den Blockfehlererkennungscode erkannt worden wären.

EZP = 1,      dass die genannte Summe einen Wert ungleich Null ergibt, und dass gar keine Fehler aufgetreten sind, die durch den Blockfehlererkennungscode erkannt worden wären.

Dabei bezieht sich alles rechts von der Diagonalen 58 nur auf $Q_0$- und $Q_1$-Wortgruppen, alles was links von der Diagonalen 58 liegt nur auf $P_0$- und $P_1$-Wortgruppen. In den übrigen Feldern bedeutet EWK, dass das betreffende Fehlerbild korrigierbar ist, MPZ, dass alle Daten- und Korrekturwörter einer Q- oder P-Wortgruppe mit einer entsprechenden Markierung zu versehen sind und MKW, dass das erste Datenwort 1 eines Blockes 19 mit einer Wortmarkierung zu versehen ist.

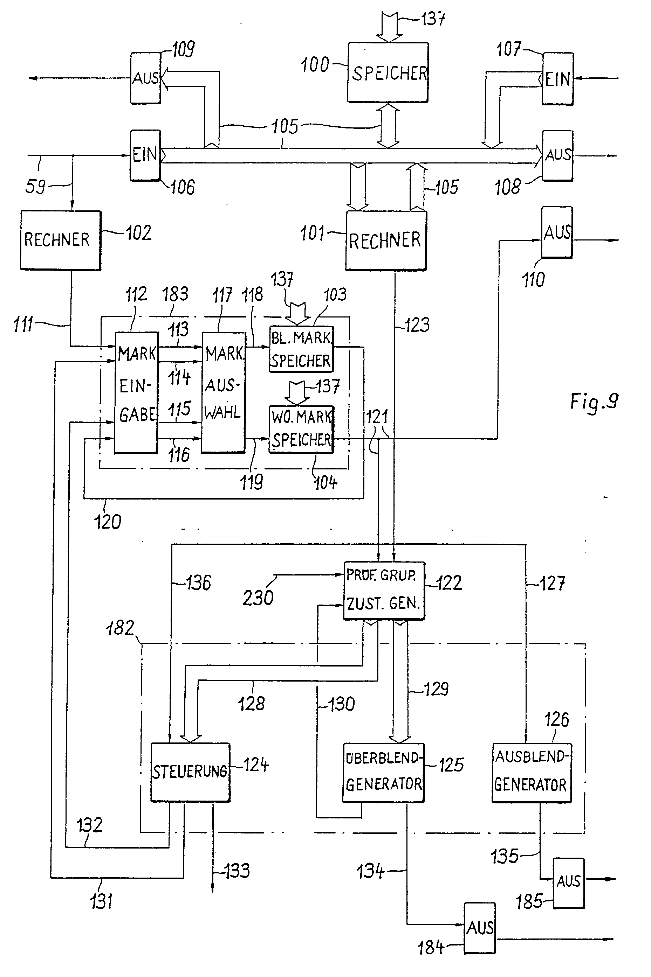

Figur 9 zeigt eine Vorrichtung zum Kombinieren und Rekombinieren von Datenwörtern. Diese besteht im wesentlichen aus einem Speicher 100 für Daten- und Korrekturwörter, einer Recheneinheit 101 zur Durchführung der Q-P-Prüf- und Auswertungsoperationen, einer Blockfehlererkennungscode-Recheneinheit 102, einem Blockfehlermarkierungsspeicher 103 und einem Wortfehlermarkierungsspeicher 104. Diese sind Teil einer Zuordnungsschaltung 183 für Block- und Wortfehlermarkierungen. Ein Datenbus 105 verbindet den Speicher 100 und die Recheneinheit 101 mit Dateneingabeeinheiten 106 und 107 und Datenausgabeeinheiten 108 und 109. Eine weitere Ausgabeeinheit 110 ist für Wortmarkierungen vorgesehen. Die Recheneinheit 102 ist über eine Leitung 111 mit einer Markierungseingabe 112 und diese wiederum über Leitungen 113, 114, 115 und 116 mit einer Markierungsauswahleinheit 117 verbunden. Diese ist über die Leitungen 118 und 119 mit dem Blockmarkierungsspeicher 103 und dem Wortmarkierungsspeicher 104 verbunden. Andererseits ist der Blockmarkierungsspeicher 103 über eine Leitung 120 mit der Markierungseingabe 112 verbunden. Eine Leitung 121 verbindet den Wortmarkierungsspeicher 104 mit der Ausgabeeinheit 110 sowie mit einem Prüfgruppenzustandsgenerator 122. Dieser ist über Leitung 123 auch mit der Recheneinheit 101 verbunden. Dem Prüflinienzustandsgenerator 122 sind parallel eine Steuerschaltung 124 zur Fehlerkorrektur von kurzen Einzel-Schreib- und Lesefehlern, sowie ein Schreibfehlerdetektor und Ueberblendgenerator 125 nachgeschaltet.

Parallel zum Prüflinienzustandsgenerator 122 mit der Steuerschaltung 124 und dem Schreibfehlerdetektor und Ueberblendgenerator 125 ist ferner ein Lesefehlerdetektor und Ausblendgenerator 126 vorgesehen, der über eine Leitung 127 und Leitung 121 mit dem Wortmarkierungsspeicher 104 verbunden ist. Der Prüflinienzustandsgenerator 122 ist über je einen Bus 128 und 129 mit der Steuerschaltung 124 und dem Ueberblendgenerator 125 verbunden. Zusätzlich verbindet eine Leitung 130 diesen mit dem Prüfgruppenzustandsgenerator 122. Die Steuerschaltung 124 hat ferner zwei Verbindungen 131 und 132 zur Markierungseingabe 112 sowie einen weiteren Ausgang 133. Zudem besteht eine Verbindung 136 zwischen der Steuerschaltung 124 und Leitung 121 bzw. dem Wortmarkierungsspeicher 104. Ausgänge 134 und 135 des Ueberblendgenerators 125 und des Ausblendgenerators 126 münden je in eine Ausgabeeinheit 184 und 185. Die Steuerschaltung 124 zur Fehlerkorrektur von kurzen Einzel-Schreib- und Lesefehlern, der Schreibfehlerdetektor und

5

Ueberblendgenerator 125 sowie der Lesefehlerdetektor und Ausblendgenerator 126 bilden zusammen eine Entscheidungseinheit 182.

Der Speicher 100, der Blockmarkierungsspeicher 103 sowie der Wortmarkierungsspeicher 104 sind alle an denselben Adressbus 137 angeschlossen.

Die Schaltung, die im wesentlichen diesen Adressbus 137 mit Adressen versieht, ist aus Figur 10a und b ersichtlich. Diese Schaltung gemäss Figur 10a enthält in an sich bekannter Weise einen Programmzähler 138, der die laufenden Programmschritte zählt und einen taktmässig damit gekoppelten Blockzähler 139. Der Programmzähler 138 ist über einen Bus 140 mit einem Adressgenerator 141 und mit einem Instruktionsgenerator 142 verbunden. Während im Adressgenerator 141 als Funktion von Programmschritten Adressen gespeichert sind, sind im Instruktionsgenerator 142 als Funktion der Programmschritte Instruktionen gespeichert. Ueber einen Bus 143 ist weiter eine Ein- und Ausgabesteuerung 144 (Fig. 11) an den Instruktionsgenerator 142 angeschlossen. Diese steuert Elemente der Vorrichtung wie Speicher, Recheneinheit usw.

Zur Ausgabe von Adressen ist dem Adressgenerator 141 je ein Bus 145, 146 und 147 für Blockadressen, Spuradressen und Wortadressen nachgeschaltet. Der Bus 146 und der Bus 147 münden in einen Eintaktspeicher 148. Dagegen mündet der Bus 145 zusammen mit einem Bus 149 von Blockzähler 139 in ein Addierglied 150, von welchem ein Bus 151 mit Blockadressen in den Eintaktspeicher 148 mündet. Je ein Bus 152, 153 und 154 für Block-, Spur- und Wortadressen verbindet den Eintaktspeicher 148 mit einem Speicheradressentreiber 155, der die Block-Spur- und Wortadressen zusammenfasst und an den Bus 137 abgibt.

Eine spezielle Ausführungsform der Schaltung gemäss Figur 10a ist in Figur 10b dargestellt. Diese weist parallel zum Blockzähler 139 einen taktmässig über Leitung 192 mit dem Eintaktspeicher 148 gekoppelten Blockversatzgenerator 156 auf, der einerseits über einen Bus 157 am Bus 154 für Wortadressen angeschlossen und andererseits über einen Bus 158 mit einem weiteren Addierglied 159 verbunden ist. Dieses ist ferner über einen Bus 160 mit dem Addierglied 150 und über einen Bus 161 mit dem Blockzähler 139 verbunden. Ueber die Leitung 133 werden dem Eintaktspeicher 148 und dem Blockversatzgenerator 156 weitere Steuersignale (enable) zugeführt. Ein Bus 163 gibt dem Blockversatzgenerator 156 auch den Arbeitstakt (Timing).

In Figur 11 ist nochmals die ganze Schaltung gemäss Figur 10b dargestellt, allerdings verknüpft mit dem Prüfgruppenzustandsgenerator 122 den bereits bekannten Leitungen 121, 123, 130 sowie den Verbindungen 131, 132 und 136. Diese Verknüpfung erfolgt dabei über Leitungen, die den Bus 128 bilden, eine Auswerteschaltung 162 einen Bus 164, eine Steuerung 165 und die Leitung 133. Der Bus 143 übermittelt Instruktionen vom Instruktionsgenerator 142 an eine Ein- und Ausgabesteuerung 144. Steuerbefehle werden entsprechend über einen Bus 166 ausgegeben. Der Arbeitstakt (Timing) wird über den Bus 163 auch dem Prüfgruppenzustandsgenerator 122 und der Auswerteschaltung 162 zugeführt.

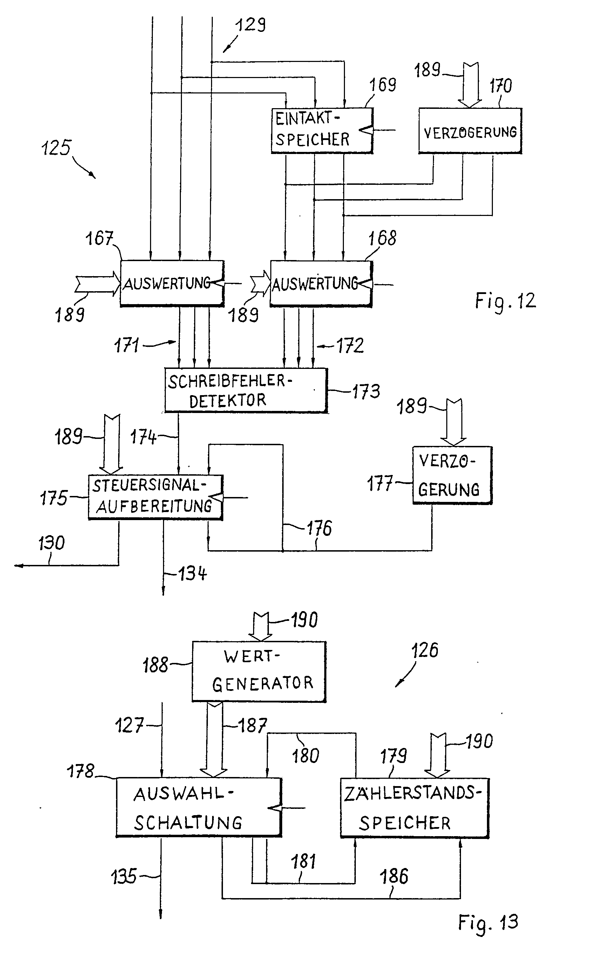

Figur 12 zeigt den Aufbau des Schreibfehlerdetektors und Ueberblendesignalgenerators 125. Dieser weist zwei getrennte Fehler-, Zähl- und Auswertungsschaltungen 167 und 168 für die $Q_1$ und $P_1$-Wortgruppen sowie für die $Q_0$- und $P_0$-Wortgruppen auf. Diese sind über den Bus 129 an den Prüfgruppenzustandsgenerator 122 angeschlossen. Der Fehler-, Zähl- und Auswertungsschaltung 168 ist ein Eintaktspeicher 169 sowie eine Verzögerungsschaltung 170 vorgeschaltet. Den Fehler-, Zähl- und Auswertungsschaltungen 167 und 168 ist über je einen Bus 171 und 172 ein Schreibfehlerdetektor 173 nachgeschaltet, wobei die Einheiten 167, 168 und 173 zusammen eine grössere Anzahl Blöcke betreffende Schreibfehler auf mehreren Spuren detektieren. Ueber eine Leitung 174 ist der Detektor 173 mit einer Steuersignalaufbereitungsschaltung 175, welche über eine Leitung 176 mit einer Steuersignalverzögerungsschaltung 177 parallel geschaltet ist, verbunden. Diese weist einen Ausgang 134 für Ueberblendsignale auf. Mit 189 sind in dieser Figur mehrere an sich bekannte Zeitsignal-Bus bezeichnet, die aber nicht jedem Element dasselbe Zeitsignal zuführen.

Figur 13 zeigt den Lesefehlerdetektor und Ausblendgenerator 126, welcher aus einer Addier-Vergleichs- und Auswahlschaltung 178 besteht, welche einerseite über Leitungen 180, 181 und 186 mit einem Zählerstandsspeicher 179 verbunden und andererseits an einen Schwellwert-Ausgangswert- und Zuwachsgenerator 188 über einen Bus 187 angeschlossen ist. Die Auswahlschaltung 178 hat weiter einen Ausgang 135 für ein Ausblendsignal, sowie einen Eingang für die Wortmarkierungen über Leitung 127. Die Addierschaltung, welche Teil der Addier-Vergleichs- und Auswahlschaltung 178 ist, bildet zusammen mit dem Zählerstandsspeicher 179 einen Zähler. Mit 190 ist auch hier ein Zeitsignal-Bus bezeichnet.

Im folgenden sei angegeben, welche der Elemente der verwendeten Schaltungen durch welche handelsüblichen Bauelemente realisiert werden können. Einfachheitshalber erfolgt lediglich eine Gegenüberstellung der Bezugszeichen und der normierten Typenbezeichnungen.

| 100 | 16k × 4 dyn RAM | 148 | 74 LS 377 |
|---|---|---|---|
| 101 | 2 × PAL 20 × 8 | 150 | 74 LS 283 |
| 102 | 9401 | 155 | 74 LS 157/244 |
| 103 | 64k × 1 dyn RAM | 156 | PAL 16 R4 |
| 104 | 64k × 1 dyn RAM | 159 | 74 LS 283 |
| 106 | 74 LS 322 | 162 | PAL 12 L6 |
| 107 | 74 LS 374 | 165 | PAL 16 R4 |
| 108 | 74 LS 377 | 167 | PAL 16 R6 |
| 109 | 74 LS 166 | 168 | PAL 16 R6 |
| 112 | 74 LS 174 | 169 | PAL 16 R4 |
| 117 | 74 LS 157 | 170 | 1024 × 4 CMOS RAM |
| 122 | PAL 16 R6 | 173 | PAL 16 R4 |
| 138 | 74 LS 169 | 177 | 1024 × 4 CMOS RAM |
| 139 | 74 LS 169 | 178 | PAL 16 R4 |
| 141 | bipolare PROM'S | 179 | 256 × 1 bip. RAM |
| 142 | | 188 | PAL 16 R8 |
| 144 | PAL 16 R8 | | |

Beim Codieren zusammengehörender Datenwörter wird deren Verarbeitung in an sich bekannter Weise aufgeteilt. Die geradzahligen und die ungeradzahligen Datenwörter werden getrennt behandelt und beispielsweise in getrennte Teile eines Speichers 100 eingelesen. Die Datenwörter werden in bekannter Weise zu Blöcken zusammengefasst. Somit werden beispielsweise längs der Linien 21 (Fig. 2, 5) die ungeradzahligen Datenwörter eingelesen. Dies geschieht über die Dateneingabe 107 und den Bus 105.

Beim Decodieren oder Rekombinieren treffen die Blöcke, bestehend aus nicht zusammengehörenden Daten- und Korrekturwörtern, in Bit-serieller Weise über Leitung 59 in der Dateneingabe 106 und in der Blockfehlererkennungscode-Recheneinheit 102 ein. Sie verlassen die Dateneingabe 106 in Wort-serieller Weise und werden im Speicher 100 entsprechend der Einleselinie 24, 31 (Fig. 2, 4) eingelesen, so dass nun die zusammengehörenden Daten- und Korrekturwörter, aufgeteilt in gerad- und ungeradzahlige Daten- und Korrekturwörter, in je einer Spalte 38 im Speicher 100 anzutreffen sind. Gleichzeitig wird der Blockfehlererkennungscode des betreffenden Blockes in der Recheneinheit 102 gelesen und ausgewertet.

Liegt beispielsweise ein Fehler derart vor, dass 30 aufeinanderfolgende Blöcke auf dem Band unlesbar werden, so ergibt sich im Speicher 100 ein Fehlerbild gemäss Fig.7a in dem Gruppen 51, 52, 53 von Datenwörtern und Gruppen 54 usw. von Korrekturwörtern unlesbar oder falsch sind. Die Funktionsweise des Decoders soll anhand dieses Beispiels erläutert werden.

Die 30 fehlerhaften Blöcke treffen in der Recheneinheit 102 ein und werden als falsch erkannt. Ueber Leitung 111 werden entsprechend 30 Blockfehlermarkierungen ausgegeben und über die Markierungseingabe 112, Leitung 113, die Markierungsauswahleinheit 117 und die Leitung 118 in den Blockmarkierungsspeicher 103 eingelesen.

Durch Ausgabe entsprechender Adressen über den Adressbus 137 werden je eine $Q_0$-Wortgruppe und eine $P_0$-Wortgruppe über den Bus 105 vom Speicher 100 in die Recheneinheit 101 eingelesen und die entsprechenden Wortmarkierungen aus dem Wortmarkierungsspeicher 104 über die Leitung 121 an den Prüfgruppenzustandsgenerator 122 angelegt. Vorausgehend wurden die Blockmarkierungen aus dem Blockmarkierungsspeicher 103 über Leitung 120, die Markierungseingabe 112, Leitung 116, die Markierungsauswahleinheit 117 und Leitung 119 an die entsprechenden, durch den Adressbus 137 übermittelten Adressen in den Wortmarkierungsspeicher 104 eingelesen.

Die Prüfung erfolgt in an sich bekannter Weise.

In der Recheneinheit 101, welche als Modulo-2-Addierwerk ausgebildet ist, werden die fehlerfreien Datenwörter einer zu prüfenden Wortgruppe aufsummiert, die Summe auf den Wert Ø geprüft (SRW) und das Resultat über Leitung 123 dem Prüfgruppenzustandsgenerator 122 zugeführt.

Im Prüfgruppenzustandsgenerator 122 wird gleichzeitig die Anzahl der fehlerhaften Wortmarkierungen in der Wortgruppe ermittelt (AWF).

Am Ende der Prüfung ergibt sich einer der vier Fälle gemäss Zeile 55 in Figur 8. Daraus generiert oder codiert der Prüfgruppenzustandsgenerator 122 Fehlersignale entsprechend den Zeilen 56 und 57 von Fig. 8.

Für unser Beispiel gilt:

AWF = 1 und SRW = X für die Q- und für die P-Wortgruppe. Es liegt somit ein Fall gemäss Feld 60 vor. Das Datenwort 59 kann in der Q- oder der P-Wortgruppe korrigiert werden.

Anschliessend an die Prüfoperation für die $Q_0$- und die $P_0$-Wortgruppe wird nacheinander eine Auswerteoperation für dieselben Wortgruppen durchgeführt; in diesem Falle also mindestens eine Korrekturoperation.

Bei der Auswerteoperation werden in einem ersten Durchlauf in bekannter Art die fehlerfreien Datenwörter einer Wortgruppe in der Recheneinheit 101 aufsummiert und gespeichert. Da nur ein einziges fehlerhaftes Wort aufgetreten ist, entspricht die Summe gerade dem Wert der fehlerhaften Datenwörter (Paritätscode).

In einem zweiten Durchlauf gibt die Steuerschaltung 124 aufgrund der aus dem Prüfgruppenzustandsgenerator 122 an sie angelegten Signale über den Bus 128 und der über Leitung 136 aus dem Wortmarkierungsspeicher 104 angelegten Signale ein Signal (1 statt Ø) über Leitung 133 an den Eintaktspeicher 148 ab, in welchem gerade die Adresse des fehlerhaften Datenwortes und seiner Wortmarkierung gespeichert ist.

Das bedeutet, dass die Adressen die der Eintaktspeicher 148 über den Bus 152, 153, 154, den Speicheradressentreiber 155 und den Bus 137 am Speicher 100 und am Wortmarkierungsspeicher 104 anlegt, solange angelegt bleiben, bis aufgrund eines Steuerbefehles über den Bus 166 das richtige Datenwort im Speicher 100 und eine richtige Wortmarkierung über die Leitung 132, die Markierungseingabe 112, Leitung 115, die Markierungsauswahleinheit 117 und Leitung 119 im Wortmarkierungsspeicher 104 eingetragen ist. Darauf folgt die Auswertungsoperation für die $P_0$-Wortgruppe.

Auf die gleiche Art und Weise wird anschliessend eine Prüfoperation und eine Auswertungsoperation für die $Q_1$- und $P_1$-Wortgruppen (Fig. 6) durchgeführt. Da für diesen Fall das Datenwort 59 in Figur 7 vergleichsweise in Figur 6 an der Stelle des Datenwortes 1 steht, ist, nun wieder in Figur 7 betrachtet, die Umgebung in der $Q_1$- und $P_1$-Wortgruppen liegen, fehlerfrei.

Anhand von Figur 10a, soll nun auch kurz die Erzeugung der Adressen für die einzelnen Verfahrensschritte erläutert werden. Der Programmzähler 138 enthält eine Anzahl modularer Programmschritte die periodisch in derselben Reihenfolge ablaufen, gespeichert. Er zählt diese gesteuert von einem Taktsignal, das ihm über Leitung 191 zugeführt wird. Seinen Zählerstand gibt er laufend dem Adressgenerator 141 und dem Instruktionsgenerator 142 weiter. Aufgrund der angelegten Zahl, gibt der Instruktionsgenerator 142 eine Instruktion über den Bus 143 ab, und der Adressgenerator 141 gibt Block-Spur- und Wortadressen an den Bus 145, 146 und 147 ab. Der Blockzähler 139 zählt die im Decoder eintreffenden Blöcke laufend und führt in jedem Takt die Zahl über den Bus 149 dem Addierglied 150 zu. So entsteht an dessen Ausgang im Bus 151 eine laufende Blockadresse. So geschieht es auch, dass zu einem bestimmten Zeitpunkt im Eintaktspeicher 148 als Wortadresse diejenige des falschen Datenwortes 59 anliegt. Dann geht vom Instruktionsgenerator 142 auch die entsprechende Instruktion über den Bus 143 auf die Ein- und Ausgabesteuerung 144 und über Leitung 193 auf die Steuerung 165, so dass diese das geeignete Signal über Leitung 133 abgeben kann, wie bereits behandelt.

Bis zum Datenwort 61 in Figur 7 können nun, ausgehend vom Datenwort 59, alle dazwischenliegenden Datenworte, auf dieselbe Weise korrigiert werden.

Im Bereiche zwischen den Datenwörtern 61 und 62 enthält jede Q- und P-Wortgruppe mindestens zwei falsche Datenoder Korrekturwörter, wie aus Figur 7 ersichtlich. Diese falschen Daten- und Korrekturwörter sind zur Zeit der Prüfoperationen über die betreffenden Wortgruppen, wie bereits beschrieben, im Wortmarkierungsspeicher 104 markiert. Da in einer Q-P-Wortgruppe nur dann ein Datenwort korrigiert werden kann, wenn in der Wortgruppe ein einziges Daten- oder Korrekturwort falsch ist, kann im Bereiche zwischen den Datenwörtern 61 und 62 die $Q_1$-Wortgruppe als erste beispielsweise das Datenwort 63 korrigieren. Die $P_1$-Wortgruppe wird dann, wie später ausführlich beschrieben, relativ zur $Q_1$-Wortgruppe um 1 × 2 Blöcke verschoben, so dass sie das Datenwort 63 enthält. Auf diese Weise kann das Datenwort 64 korrigiert werden. Die $Q_1$- und $P_1$-Wortgruppen sind somit in der Lage, alle falschen Datenwörter der Gruppen 51 und 52 zwischen den Datenwörtern 61 und 62 zu korrigieren. Die Datenwörter 65, 66, 67 und 68 der Gruppe 52 lassen sich wiederum durch die $P_0$-Wortgruppe allein korrigieren. Das Datenwort 69 kann wieder durch die $Q_1$-Wortgruppe korrigiert werden. Um aber das Datenwort 70 korrigieren zu können, wird die $P_1$-Wortgruppe gegenüber der Wortgruppe $Q_1$ um 2 × 2 Blöcke nach links oder zeitlich vorverschoben, so dass sich die $Q_1$- und die $P_1$-Wortgruppe im Datenwort 69 schneiden. Auf diese Weise können wiederum alle Datenworte der Gruppen 52 und 53 bis zum Ende der Gruppe 52 korrigiert werden usw.

Bei einem Code mit 4 Korrekturwörtern auf 12 Datenwörter und einem Spreizabstand von 17 Blöcken

8

und einer Neigung von Q zu P von 2 Blöcken, wie das z.B. für dem Crossinterleave Code im DASH-Format zutrifft, lassen sich auf diese Weise 30 aufeinanderfolgende falsche Blöcke korrigieren.

Um dieses Korrekturverfahren mit gegenüber der $Q_1$-Wortgruppe variabler $P_1$-Wortgruppe durchzuführen, findet die Erzeugung der Adressen für die $P_1$-Wortgruppe gemäss der Anordnung statt, wie sie in Figur 10b oder 11 gezeigt ist. Diese arbeitet in der bereits für die Figur 10a beschriebenen Weise mit der Abweichung, dass die Wortmarkierung in der korrigierbaren $Q_1$-Wortgruppe benützt wird, um eine neue Blockadresse für die $P_1$-Wortgruppe zu erzeugen. Dies geschieht dann, wenn der Adressgenerator 141 die Adressen jener Daten- und Korrekturwörter ausgibt, die einer Prüfoperation unterzogen werden. Diese Adressen werden auch dem Wortmarkierungsspeicher 104 zugeleitet, der, wenn die Adresse eines falschen Datenwortes anliegt, ein Signal über die Leitungen 121 und 136 an die Steuerung 165 abgibt, die ihrerseits ein Signal über Leitung 133 am Eintaktspeicher 148 und am Blockversatzgenerator 156 anlegt.

Da die Leitung 133 die Adresse eines fehlerhaften aber korrigierbaren Datenwortes anzeigt, wird sie dazu benützt, um einerseits im Eintaktspeicher 148 das Einlesen einer neuen Adresse für einen Takt zu verhindern, was bewirkt, dass in diesem folgenden Takt an derselben Adresse das korrigierte Datenwort in den Speicher 100 geschrieben werden kann und andererseits um dem Blockversatzgenerator 156 anzuzeigen, wann er die Wortadresse in einem Korrekturschritt einer $Q_1$-Wortgruppe ablesen darf.

Aufgrund der Adresse dieses markierten falschen Daten- oder Korrekturwortes, die dem Blockversatzgenerator 156 über den Bus 157 zugeleitet wird, rechnet dieser den Blockversatz aus. Diese Zahl wird über den Bus 158 dem Addierglied 159 zugeführt, wo sie zu der laufenden Blockzahl addiert wird. Dieses Resultat gelangt über den Bus 160 in das Addierglied 150, aus dem eine veränderte Blockadresse über den Bus 151 zum Eintaktspeicher 148 gelangt.

Sind mehr als 30 Blöcke durch den Blockfehlererkennungscode als falsche Blöcke markiert, so werden die entsprechenden Daten- und Korrekturwörter in bereits beschriebener Weise in den Wortmarkierungsspeicher 104 eingelesen und über Leitung 121 und die Ausgabeeinheit 110 einer an sich bekannten und hier nicht näher dargestellten Interpolationsschaltung zugeführt, in der Datenworte durch Interpolation aus benachbarten Worten ersetzt werden können.

Bei Lesefehler wird ab 289 aufeinanderfolgenden, als falsch markierten Blöcken das Ausgangssignal ausgeblendet (Muting). Ausblendung des Ausgangssignales ist andererseits ab vier aufeinanderfolgenden als falsch markierten Datenwörtern notwendig.

Bei der Aufzeichnung von Musiksignalen bei niederiger Bandgeschwindigkeit werden die Audiodaten nach einer bestimmten Vorschrift auf auf 4 Spuren des Datenträgers verteilt.

Das hat zur Folge, dass beim Zusammensetzen des Audiosignales aus 4 verschiedenen Spuren Muster fehlerhafter Datenwörter entstehen, die gehörmässig angepasst, verarbeitet werden müssen, d.h. z.B. Interpolation bis höchstens 3 aufeinanderfolgende Datenwörter.

Wegen der Notwendigkeit des Ausblendens sind die Zyklen zum Einlesen und Auslesen von Daten in den Speicher 100 und den Wortmarkierungsspeicher 104 so gewählt, dass zu dem Zeitpunkt, zu dem uncodierte Datenwörter in den Speicher 100 eingelesen werden (Linie 21 in Fig. 5) gleichzeitig die Wortmarkierungen der decodierten Datenwörter aus dem Wortmarkierungsspeicher 104 ausgelesen werden. Dies geschieht um die Zeit $\triangle_t$ bevor die entsprechenden decodierten Datenwörter aus dem Speicher 100 (Linie 26, Fig. 4) ausgelesen werden. Zum Auslesen der Wortmarkierungen aus dem Wortmarkierungsspeicher 104 werden dieselben Adressen benützt, die zum Einlesen der noch nicht codierten Datenwörter in den Speicher 100, vom Adressbus 137 angelegt werden. Die Zeit $\triangle_t$ entspricht der Zeit, die benötigt wird, um eine Ausblendung durchzuführen. Die Wortmarkierungen aufeinanderfolgender falscher Datenwörter werden über die Leitungen 121 und 127 dem Lesefehlerdetektor und Ausblendgenerator 126 und somit übersteigt die gezählte Anzahl Wortmarkierungen den Schwellwert, so gibt die Vergleichsschaltung 178 über den Ausgang 135 ein Ausblendsignal ab. In diesem Zeitpunkt startet ein zweiter Zählvorgang der gleich abläuft wie der erste Zählvorgang, allerdings mit dem Unterschied, dass nun statt Wortmarkierungen aus Leitung 127 gezählt, der Zählerstand durch den Zuwachsgenerator 188 schrittweise erhöht wird, bis ein zweiter, darin gespeicherter Schwellwert erreicht wird. Dadurch wird auch das Ausblendsignal wieder rückgängig gemacht. Der erste Zählvorgang startet jedesmal dann wieder neu, wenn die Folge aufeinanderfolgender falscher Wortmarkierungen unterbrochen wird und so der Schwellwert nie erreicht wird. Da die Wortmarkierungen den Daten um die Zeit $\triangle_t$ voreilen, kann die Ausblendung der Datenwörter rechtzeitig eingeleitet werden.

Die Addier-, Vergleichs- und Auswahlschaltung 178 arbeitet seriell innerhalb einer Abtast- oder Datenwortperiode. In einem ersten Schritt finden hintereinander für zwei Zähler eine Addition und ein Vergleich parallel statt.

In einem zweiten Schritt werden hintereinander für zwei Zähler gemäss der Auswahl für den ersten und den zweiten Zähler die Schreibbefehle für den Zählerstandsspeicher 179 generiert und über Leitung 186 über mittelt, sowie parallel dazu das Ausblendesignal generiert und über die Leitung 135 einer nicht näher bezeichneten datenverarbeitenden Einheit zugeführt.

Ueberschreibfehler können dann auftreten, wenn auf einem Magnetband alte Daten ohne vorausgehende Löschung durch neue Daten überschrieben werden, und wenn zudem der Schreibmechanismus durch Staubteilchen gestört wird. Zur weiteren Erläuterung der Funktionsweise der Vorrichtung sei angenommen, dass gemäss Figur 7b auf zwei aufeinanderfolgende Datenblöcke mit Datenwörtern 200, 201, 202 und 204, 205, 206, zwei Datenblöcke mit Datenwörtern 208, 209, 210 und 211,

9

212, 213 mit alten Daten folgen. Auf diese folge wiederum ein Block mit Datenwörtern 214, 215, 216. Es sei weiter angenommen, dass Datenblöcke für neue Daten und alte Daten einen eindeutigen magnetischen Pegel aufweisen, während Datenblöcke im Uebergang von neuen zu alten Blöcken und umgekehrt keinen eindeutigen magnetischen Pegel aufweisen sollen. Den ersten Datenblöcken 200 bis 203 gehen Datenblöcke mit neuen Daten voraus.

Für die ersten zwei Blöcke mit den Datenwörtern 200 bis 206, die keinen eindeutigen magnetischen Pegel aufweisen, gilt:

Der Block gelangt über Leitung 59 zuerst in die Blockfehlererkennungscoderecheneinheit 102. Das Resultat der dortigen Auswertung, eine Blockfehlermarkierung wird über Leitung 111 in die Zuordnungsschaltung 183 eingegeben. Entsprechend sind die genannten Datenwörter 200 bis 206 in bekannter Weise in den Speicher 100 eingelesen und einer Prüfoperation in $Q_0$- und $P_0$-Wortgruppen in der Recheneinheit 101 unterzogen. Die von der Recheneinheit 101 über Leitung 123 ausgegebenen Fehlersignale(SRW), zusammen mit den Wortmarkierungen für die genannten Datenwörter aus der Zuordnungsschaltung 183 in Leitung 121 ergeben ein Fehlerbild gemäss dem Feld 60 in Figur 8, Diese Datenwörter 200 bis 206 werden gleich wie das Datenwort 59 in Fig. 7a behandelt.

Für die weiteren zwei Blöcke mit den Datenwörtern 208 bis 213, die einen eindeutigen magnetischen Pegel aufweisen, gilt:

Die Blockfehlererkennungscoderecheneinheit 102 erkennt diese Blöcke als fehlerfrei und gibt das entsprechende Signal über Leitung 111 an die Zuordnungsschaltung 183 ab.

Die Datenwörter 208 bis 216 gelangen als richtig markiert in die Prüfung in der Recheneinheit 101, wo zuerst das Datenwort 208 bzw. 211 zur Prüfung gelangt. Dieses wird dort als falsch erkannt, weil es gleichzeitig Teil einer $Q_0$- und $P_0$-Wortgruppe ist, die je ein falsches Datenwort enthalten. Dies entspricht einem Fehlerbild gemäss Feld 71 in Figur 8.

Der Instruktionsgenerator 142 enthält einen Programmteil, der veranlasst, dass einerseits die Wortmarkierung des fehlerhaften Datenwortes 208 oder 211 als fehlerhaft markiert wird und andererseits die Blockmarkierung des Blockes 19 aus dem das fehlerhafte Datenwort 208 stammt, im Blockmarkierungsspeicher 103 als fehlerhaft markiert wird.

Sobald dieser Vorgang abgeschlossen ist, wird der Prüfgruppenzustandsgenerator 122 mit einem Taktsignal über Leitung 230 aus dem Zustand Q-EZP = 1, Q-ZKA = Ø, P-EZP = 1, P-ZKA = Ø zurückgesetzt auf den Zustand Q-EZP = Ø, Q-ZKA = Ø, P-EZP = 0, P-ZKA = Ø, was bedeutet, dass die Prüfgruppen $Q_0$ oder $P_0$ jetzt korrigierbar sind. Die jetzt markierten Datenwörter 208, 211 erfahren sodann die gleiche Behandlung wie etwa die Datenwörter 59 und 259 gemäss Figur 7.

Da die Blockmarkierung im Blockmarkierungsspeicher 103 nicht gleichzeitig wie die Datenwörter in den Speicher 100, sondern bereits zur Zeit der Prüfung der vorausgehenden Q-Wortgruppe eingelesen wird, erscheinen die Datenwörter 209 und 210 und die folgenden Datenwörter dieses Blockes 19 bereits mit der neuen Wortmarkierung. Auf diese Weise können bis zu 15 aufeinanderfolgende falsche Blöcke korrigiert werden.

Für den Block mit den Datenwörtern 214 bis 216 ohne eindeutigen magnetischen Pegel, gilt dasselbe wie die Blöcke mit den Datenwörtern 200, 201, 202 und 204, 205, 206. Das bedeutet, dass für die weitere Verarbeitung die Datenwörter 200 bis 216 markiert sind, wie wenn sie zu fünf aufeinanderfolgenden falschen Blöcken gehören würden.

Um die Schnittstelle zweier zusammengesetzter Magnetbänder derart zu überbrücken, dass an dieser Stelle und in dessen Umgebung die chaotische Daten- und Korrekturwörter-Vermischung keine chaotische Wiedergabe ergibt, wird an dieser Stelle ein geordneter Ueberblendvorgang veranlasst. Dabei wird berücksichtigt, dass auf dem Magnet band mehrere Spuren mit beispielsweise Audiodaten vorgesehen sind. Die Vorrichtung behandelt alle Spuren im Zeit-Multiplex-Verfahren.

Um die Schnittstelle festzustellen, darf die Vorrichtung das Auftreten der die Schnittstelle charakterisierenden Fehler nicht verwechseln mit Einzelfehlern, die gelegentlich auf einzelen Spuren auftreten können, die sich aber im Durchschnitt meistens auf 1 bis 3 Blöcke beschränken. Deshalb werden zum Entscheid, ob eine Schnittstelle vorliegt oder nicht, die Fehler auf allen Spuren zusammen zentral in ihrer Gesamtheit interpretiert. Dies geschieht laufend im Schreibfehlerdetektor und Ueberblendgenerator 125 (Fig 12).

Ueber den Bus 129 gibt der Prüfgruppenzustandsgenerator 122 laufend und multiplexiert die Signale ZKA, EZP, CRC an den Ueberblendgenerator 125 ab. Dieser speichert die entsprechenden Signale, die aus $Q_0$- und $P_0$-Wortgruppen abgeleitet sind zuerst im Speicher 169 und dann in der Verzögerungsschaltung 170 während der Verarbeitungszeit von 14 Blöcken, d.h., bis entsprechende Signale für die zugehörige $Q_1$- und $P_1$-Prüfgruppe verfügbar sind. Dann werden die Signale gleichzeitig einerseits in der Fehlerauswertungsschaltung 167 und andererseits in der Fehlerauswertungsschaltung 168 eintreffen. Diese Wartezeit entsprechend 14 Blöcken erlaubt es, Fehler aufgrund einer Schnittstelle gegenüber Einzelfehlern zu unterscheiden. Liegen die Resultate der Fehlerauswertungen über alle Spuren aus den Schaltungen 167 und 168 vor, so wird daraus, abgeleitet im Detektor 173, ein gemeinsames Signal als Resultat eines Mehrheitsentscheides erzeugt und über Leitung 174 ausgegeben. Dieses Resultat wird für die Verarbeitung des nächsten, d.h. des 15ten Blockes ab Eintreffen des ersten Fehlersignales wirksam. In diesem nächsten Block und für die weiteren Blöcke gemäss der Anzahl Blöcke (ODD/EVEN Versatz-Ueberblendezeit) gibt die Steuersignalaufbereitungsschaltung 175 über Leitung 130 ein Signal an den

10

Prüfgruppenzustandsgenerator 122 ab. Dieser veranlasst über die Steuerschaltung 124 für die $P_1$-Wortgruppe gültige Wortmarkierungen im Wortmarkierungsspeicher 104, die die betreffenden Daten- (und Korrekturwörter) als falsch erscheinen lassen. Parallel dazu gibt die Steuersignalaufbereitungsschaltung 175 über Leitung 176 ein Signal in die Steuersignalverzögerungsschaltung 177, das dort solange aufgehoben wird, bis die Markierung der Daten- und Korrekturwörter in der $P_1$-Wortgruppe abgeschlossen ist. Nach dieser Zeit wird dieses Signal aus der Steuersignalverzögerungsschaltung 177 zurückgenommen.

Sobald alle markierten Datenwörter der ersten Datenhälfte aus dem Speicher 100 ausgelesen sind, wird über Leitung 134 das Startsignal zum Ueberblenden ausgegeben.

**Patentansprüche**

1. Verfahren zum Decodieren einer ersten Folge von digitalen Datenwoertern (1 bis 12) und Korrekturwoertern (13 bis 16), die in einer ersten Reihenfolge auftreten, wobei die Datenwoerter und Korrekturwoerter dieser ersten Folge so neu kombiniert werden, dass eine zweite Folge mit einer zweiten Reihenfolge der Datenwoerter und Korrekturwoerter entsteht, wobei die erste Folge in Bloecke (19) eingeteilt ist, die mehrere Datenwoerter und mehrere Korrekturwoerter in der ersten Reihenfolge angeordnet enthalten und wobei eine erste Wortgruppe ($Q_0$) und eine zweite Wortgruppe ($P_0$) mit Datenwoertern und Korrekturwoertern gebildet wird, dadurch gekennzeichnet, dass die erste und die zweite Wortgruppe ($Q_0$, $P_0$) so gebildet werden, dass sie ein Wort (1) gemeinsam haben, dass dieses gemeinsame Wort auch das erste Wort in einem Block (19) der ersten Folge ist, dass die Datenwoerter und Korrekturwoerter der ersten und der zweiten Wortgruppe in einem ersten Schritt je einer Pruefoperation unterzogen werden, wobei in beiden Wortgruppen mindestens ein Wort als falsch erkannt werden kann, dann aber daraus nicht bekannt ist welches Wort falsch ist, dass fuer die Datenwoerter und Korrekturwoerter der ersten und zweiten Wortgruppe in einem zweiten Schritt das Resultat der pruefoperation ausgewertet wird, wobei unter den falschen Woertern beider Wortgruppen sicher mindestens das gemeinsame Wort als falsch erkannt werden kann, dass entschieden wird, ob falsche Woerter korrigiert werden koennen und dass die korrigierbaren falschen Woerter mit Hilfe der Korrekturwoerter korrigiert werden, wenn es die Auswertung erlaubt.

2. Verfahren gemaess Anspruch 1, dadurch gekennzeichnet, dass aus der zweiten Folge eine dritte Wortgruppe ($Q_1$) und eine vierte Wortgruppe ($P_1$) gebildet wird, dass die dritte Wortgruppe einerseits mit der zweiten Wortgruppe ($P_0$) und andererseits mit der vierten Wortgruppe ($P_1$) je ein Datenwort gemeinsam hat, dass das erste Datenwort der vierten Wortgruppe ($P_1$) und das letzte Datenwort der zweiten Wortgruppe ($P_0$) als gemeinsame Datenwoerter mit der dritten Wortgruppe ($Q_1$) vorgesehen sind, und dass die dritte und die vierte Wortgruppe ($Q_1$ und $P_1$) zusammen in einem dritten Schritt Pruefoperationen und in einem vierten Schritt Auswertungsoperationen unterzogen werden.

3. Verfahren gemaess Anspruch 1, dadurch gekennzeichnet, dass jedem Block (19) der ersten Folge ein Blockfehlererkennungscode (17) zugefuegt wird, dass der Block (19) einer Pruefung des Blockfehlererkennungscodes unterworfen wird, dass aufgrund des Resultates dieser Pruefung dem Block (19) eine Blockmarkierung zugeordnet wird, die den Block (19) als richtig oder falsch zusammengesetzt kennzeichnet, dass jedem Datenwort und jedem Korrekturwort dieses Blockes (19) als Folge der Blockmarkierung eine Wortmarkierung zugeordnet wird, die das Daten- oder Korrekturwort als richtig oder falsch bezeichnet, dass den Daten- und Korrekturwoertern, den Blockmarkierungen und den Wortmarkierungen je ein eigener Verarbeitungskanal zugewiesen wird, und dass die Zuordnung der Wortmarkierungen zu Daten- und Korrekturwoertern zeitlich in einer Wortgruppe erfolgt, die einer Wortguppe ($Q_0$) unmittelbar vorausgeht welche gerade einer Pruefoperation unterzogen wird, um eine Veraenderung der Blockmarkierung zwischen der Zeit der Verarbeitung eines ersten Datenwortes (1) und der Zeit der Verarbeitung aller uebrigen Daten- und Korrekturwoerter (2 bis 16) des Blockes (19), aufgrund des Fehlerbildes zu ermoeglichen.

4. Verfahren gemaess Anspruch 2, dadurch gekennzeichnet, dass jedem Daten- und Korrekturwort eine Wortmarkierung zugeordnet wird, die das betreffende Daten- oder Korrekturwort als richtig oder falsch bezeichnet, dass die Wortmarkierung eines falschen Daten- oder Korrekturwortes in der dritten Wortgruppe ($Q_1$) verwendet wird, um dasjenige Daten- oder Korrekturwort zu bestimmen, das mit einer vierten Wortgruppe ($P_1$) gemeinsam ist, welche einer Auswertungsoperation unterzogen wird.

5. Verfahren gemaess Anspruch 3 oder 4, wobei jedem Block (19) ein Blockfehlererkennungscode (17) zugeordnet wird, dadurch gekennzeichnet, dass durch Auswerten des Blockfehlererkennungscode (17) und durch Auswertungsoperationen ueber die Wortgruppen ($Q_0$ bis $P_1$) Fehlersignale erzeugt werden, dass aufgrund dieser Fehlersignale Steuersignale erzeugt werden fuer die nachfolgende Verarbeitung der Datenwoerter.

6. Verfahren gemaess Anspruch 5, dadurch gekennzeichnet, dass als nachfolgende Verarbeitung ein Ueberblenden von Datenwoertern vorgesehen ist.

7. Verfahren gemaess Anspruch 5, dadurch gekenzeichnet, dass als nachfolgende Verarbeitung ein Ausblenden von Datenwoertern vorgesehen ist.

8. Verfahren gemaess Anspruch 5, dadurch gekennzeichnet, dass als nachfolgende Verarbeitung eine Ausgabe der Datenwoerter zusammen mit entsprechenden Wortmarkierungen erfolgt.

9. Verfahren gemaess Anspruch 5, wobei Bloecke (19) auf mehreren Spuren eines Aufzeichnungstraegers aufgezeichnet sind, dadurch gekennzeichnet, dass fuer jede Spur Fehlersignale erzeugt werden, dass die Fehlersignale aller Spuren zur Ermittlung eines Fehlerbildes verwendet werden, und dass die Entscheidung fuer Steuersignale aufgrund der Fehlersignale aus einer Mehrzahl der Spuren getroffen wird.

10. Verfahren gemaess Anspruch 7, dadurch gekennzeichnet, dass zum rechtzeitigen Erzeugen eines Ausblendsignales fuer die Datenwoerter, Einleseadressen zum Einlesen einer Folge von Datenwoertern in der zweiten Ordnung in einen Speicher zum Codieren und Ausleseadressen zum Auslesen der Datenwoerter in der zweiten Ordnung aus einem Speicher beim Decodieren um eine Zeit zueinander versetzt sind, und dass Wortmarkierungen fuer rekombinierte Datenwoerter mit Hilfe der genannten Einleseadressen aus einem Speicher fuer Wortmarkierungen ausgelesen werden.

11. Verfahren gemaess Anspruch 7, dadurch gekennzeichnet, dass aufeinanderfolgende falsche Wortmarkierungen gezaehlt und laufend mit einem gegebenen ersten Schwellwert verglichen werden, dass bei Erreichen des ersten Schwellwertes ein Ausblendsignal ausgegeben wird, dass bei Erreichen des ersten Schwellwertes Impulse eines Zuwachsgenerators (188) gezaehlt und laufend mit einem zweiten Schwellwert verglichen werden, und dass bei Erreichen des zweiten Schwellwertes das Ausblendsignal wieder ausgeschaltet wird.

12. Vorrichtung zur Durchfuehrung des Verfahrens nach Anspruch 1, mit

einem Speicher (100) wo die Daten- und Korrekturwoerter in der ersten Reihenfolge eingelesen und in der zweiten Reihenfolge ausgelesen werden, mit

einer Recheneinheit (101), welche an den Speicher (100) angeschlossen ist und Pruefoperationen und Auswertungsoperationen an ersten und zweiten Wortgruppen, welche im Speicher (100) gebildet werden, durchfuehren kann, mit

einer Recheneinheit (102) zur Auswertung eines Blockfehlererkennungscodes, die zum Speicher (100) parallel geschaltet ist und aus eintreffenden Daten- und Korrekturwoertern Blockfehlererkennungscodewoerter ermittelt und mit vorhandenen Blockfehlererkennungscodewoertern vergleicht, wodurch weitere Hinweise auf falsche Daten-und Korrekturwoerter verfuegbar werden, gekennzeichnet durch

eine Zuordnungsschaltung (183) welche an die Recheneinheit (102) zur Auswertung eines Blockfehlererkennungscodes angeschlossen ist und zur Unterstuetzung der Auswertungsoperationen den Datenwoertern Blockmarkierungen und Wortmarkierungen zuordnet, wonach die betreffenden Bloecke und Woerter als richtig oder falsch erkannt sind, un welche einen Blockmarkierungsspeicher (103) und einen diesem nachgeschalteten Wortmarkierungsspeicher (104) enthaelt, deren Inhalt unabhaengig voneinander veraenderbar ist, so dass waehrend der Auswertung im zweiten Schritt Wortmarkierungen im Wortmarkierungsspeicher (104), fuer bereits korrigierte Woerter wie das den beiden Wortgruppen gemeinsame Wort, veraendert werden koennen und weitere nachfolgende Auswertungen im zweiten Schritt mit angepassten Wortmarkierungen durchgefuehrt werden koennen.

13. Vorrichtung gemaess Anspruch 12, gekennzeichnet durch einen Pruefgruppenzustandsgenerator (122) der an den Wortmarkierungsspeicher (104) und an die Recheneinheit (101) zur Berechnung und Auswertung der Korrekturwoerter (13 bis 16) angeschlossen ist.

14. Vorrichtung gemaess Anspruch 13, gekennzeichnet durch eine Steuerschaltung (124) zur Fehlerkorrektur von kurzen Einzel- Schreib- und Lesefehlern, die Blockmarkierungen, Wortmarkierungen und Steuersignale als Funktion von Ausgangssignalen des Pruefgruppenzustandsgenerators (122) und des Wortmarkierungsspeichers (104) erzeugt sowie durch einen Schreibfehlerdetektor und Ueberblendgenerator (125) der ein Ueberblendsignal sowie Steuersignale fuer Wortmarkierungen als Funktion von Signalen des Pruefgruppenzustandsgenerators (122) erzeugt.

15. Vorrichtung gemaess Anspruch 12, gekennzeichnet durch einen Lesefehlerdetektor und Ausblendgenerator (126) der ein Ausblendsignal als Funktion von Wortmarkierungen aus dem Wortmarkierungsspeicher (104) erzeugt.

16. Vorrichtung gemaess Anspruch 13, dadurch gekennzeichnet, dass der Pruefgruppenzustandsgenerator (122) so ausgebildet ist, dass er als Funktion des Fehlerzustandes in P-Q-Wortgruppen ein Ausgangssignal erzeugt, dass der Pruefgruppenzustandsgenerator (122) weitere Eingaenge (130, 230) aufweist zur Erzeugung von Ausgangssignalen infolge anderweitig erkannter Fehlerzustaende oder des eigenen Ausgangssignales.

17. Vorrichtung gemaess Anspruch 14 oder 15, dadurch gekennzeichnet, dass der Pruefgruppenzustandsgenerator (122) derart ausgebildet ist, dass seine Ausgangssignale des fuer die Steuerschaltung (124) aus einem ersten Signal (ZKA), eine nicht korrigierbare Q- oder P-Wortgruppe betreffend, und aus einem zweiten Signal (EZP), nichtzusammengehoerende Daten- oder Korrekturwoerter in einer Q- oder P-Wortgruppe betreffend, besteht, und dass die Ausgangssignale des Pruefgruppenzustandsgenerators (122) fuer den Schreibfehlerdetektor und Ueberblendegenerator (125) aus dem ersten und dem zweiten Signal (ZKA, EZP) und aus einem weiteren Signal (CRC) bestehen, das der urspruenglichen Blockmarkierung entspricht.

18. Vorrichtung gemaess Anspruch 15, dadurch gekennzeichnet, dass der Lesefehlerdetektor und Ausblendgenerator (126) aus einer seriell arbeitenden Addier- Vergleichs- und Auswahlschaltung (178),

EP 0 168 793 B1

daran angeschlossenem Schwellwert- Ausgangswert- und Zuwachsgenerator (188) und Zaehlerstandsspeicher (179) fuer Zeitmultiplexbetrieb besteht, wobei die Addierschaltung (178) und der Zaehlerstandsspeicher (179) zusammen einen ersten und einen zweiten Zaehler bilden, wobei die Addier- Vergleichs- und Auswahlschaltung (178) eine Verbindungsleitung (121, 127) mit dem Wortmarkierungsspeicher (104), einen Bus (187) Schwellwert- Ausgangswert- und Zuwachsgenerator (188) und eine Verbindungsleitung (180) mit dem Zaehlerstandsspeicher (179) als Eingang hat und ueber Ausgaenge (135, l86) ein Ueberblendsignal sowie Schreibbefehle fuer den Zaehlerstandsspeicher (179) abgibt.

**Revendications**

1. Méthode permettant de décoder une première séquence de mots de données numériques (1 à 12) et de mots de correction (13 à 16), qui apparaissent dans un premier ordre, où

les mots de données et les mots de correction de cette première séquence sont regroupés afin d'obtenir une seconde séquence avec un second ordre des mots de données et de correction, où

la première séquence est divisée en blocs (19) qui contiennent plusieurs mots de données et mots de correction dans le premier ordre et où

un premier groupe de mots ($Q_0$) et un second groupe de mots ($P_0$) contenant des mots de données et des mots de correction sont formés, caractérisée en ce que

le premier et le second groupe de mots ($Q_0$, $P_0$) sont formés de telle manière qu'ils ont un mot (1) commun, que

ce mot commun est le premier mot d'un bloc (19) de la première séquence, que

les mots de données et les mots de correction du premier et du second groupe de mots sont soumis dans une première étape à un examen où au moins un mot peut être reconnu comme faux dans les deux groupes mais où il n'est pas évident lequel des mots est faux, que

dans une seconde étape le résultat de l'examen est interprété pour les mots de données et de correction du premier et du second groupe où parmi les mots faux appartenants aux deux groupes de mots, le mot commun peut être reconnu comme faux avec certitude, en ce qu'il est décidé si des mots faux peuvent être corrigés et que les mots faux corrigibles sont corrigés avec l'aide des mots de correction si l'interprétation le permet.

2. Méthode selon la revendication 1, caractérisée en ce qu'un troisième groupe de mots ($Q_1$) et un quatrième groupe de mots ($P_1$) sont crées à partir de la seconde séquence, que

le troisième groupe de mots a un mot en commun d'une part avec le deuxième groupe de mots ($P_0$) et d'autre part avec le quatrième groupe de mots ($P_1$), que

le premier mot de données du quatrième groupe de mots ($P_1$) et le dernier mot de données du deuxième groupe de mots ($P_0$) sont des mots de données appartenants également au troisième groupe de mots ($Q_1$) et que

le troisième et le quatrième groupe de mots ($Q_1$ et $P_1$) sont soumis ensemble dans une troisième étape à un examen et dans une quatrième étape à une interprétation.

3. Méthode selon la revendication 1, caractérisée en ce qu'à chaque bloc (19) de la première séquence est ajouté un code d'identification d'erreurs dans le bloc (17), que le bloc (19) est soumis à un examen de son code d'identification d'erreurs, que suivant le résultat de cet examen le bloc (19) reçoit une marque qui indique si la composition du bloc (19) est juste ou fausse, que chaque mot de données et chaque mot de correction du bloc (19) reçoit, suivant la marque du bloc, une marque qui indique si le mot de données ou de correction est juste ou faux, qu'un propre canal de traitement est destiné aux mots de données, aux mots de correction, aux marques de blocs et aux marques de mots et que les mots de données et les mots de correction reçoivent leurs marques à un moment où un groupe de mots ($Q_0$) précédent est soumis à l'examen afin de rendre possible le changement d'une marque de bloc entre le moment où le premier mot de données (1) d'un bloc (19) est traité et le moment où les autres mots de données et de correction (2 à 16) du bloc (19) sont traités tenant compte de toutes les erreurs.

4. Méthode selon la revendication 2, caractérisée en ce que chaque mot de données et chaque mot de correction reçoit une marque qui indique si le mot en question est juste ou faux, et en ce que la marque d'un mot de données ou d'un mot de correction faux du troisième groupe ($Q_1$) est utilisée pour indiquer le mot de données ou le mot de correction qui appartient au quatrième groupe de mots ($P_1$) soumis à une interprétation.

5. Méthode selon la revendication 3 ou 4, où chaque bloc (19) reçoit un code d'identification d'erreurs dans le bloc (17), caractérisée en ce qu'à la suite de l'interprétation du code d'identification d'erreurs (17) et de l'interprétation des examens effectués sur les groupes de mots ($Q_0$ à $P_1$), des signaux indiquant des erreurs sont produits et qu'à la suite de ces signaux sont produits des signaux de commande pour le traitement suivant des mots de données.

6. Méthode selon la revendication 5, caractérisée en ce que le traitement suivant consiste à diminuer progressivement l'intensité de mots de données venant d'une source et à simultanément augmenter progressivement l'intensité de mots de données venant d'une autre source.

7. Méthode selon la revendication 5, caractérisée en ce que le traitement suivant consiste à diminuer progressivement l'intensité des mots de données.

EP 0 168 793 B1

8. Méthode selon la revendication 5, caractérisée en ce que le traitement suivant consiste à émettre des mots de données ensemble avec des marques correspondantes.

9. Méthode selon la revendication 5, où des blocs (19) sont enregistrés sur plusieurs pistes d'un support d'enregistrement, caractérisée en ce que des signaux indiquant des erreurs sont produits pour chaque piste, que ces signaux se rapportant à toutes les pistes sont utilisés pour établir un état des erreurs et qu'une décision d'émettre des signaux de commande est prise considérant les signaux indiquant des erreurs venant d'une majorité des pistes.

10. Méthode selon la revendication 7, caractérisée en ce que pour produire à temps un signal indiquant la diminution progressive de l'intensité des mots de données, les adresses d'entrée d'une séquence de mots de données dans le second ordre dans une mémoire pour le codage et les adresses de sortie d'une séquence de mots de données dans le second ordre pour le décodage sont déplacées dans le temps et que des marques de mots pour des mots de données reconstitués sont sorties d'une mémoire à l'aide des dites adresses d'entrée.

11. Méthode selon la revendication 7, caractérisée en ce que des marques de mots successives indiquant des mots faux sont comptées et que le résultat est continuellement comparé à un premier seuil, que si le premier seuil est atteint un signal provoquant la diminution progressive de l'intensité des mots de sortie est produit, que si le premier seuil est atteint les impulsions d'un générateur (188) sont continuellement comptés et le résultat comparé à un second seuil et que lorsque le second seuil est atteint, le signal provoquant la diminution de l'intensité est supprimé.

12. Appareil permettant d'exécuter la méthode selon la revendication 1, comprenant une mémoire (100) où les mots de données et les mots de correction sont entrés dans le premier ordre et sortis dans le second ordre, un processeur (101) raccordé à la mémoire (100) qui peut exécuter des opérations de vérification et d'interprétation sur des premiers et des second groupes de mots formés dans la mémoire (100), un processeur (102) pour interpréter un code indiquant les erreurs dans un bloc, arrangé en parallèle avec la mémoire (100) qui produit des mots correspondant au code indiquant les erreurs dans un bloc à partir des mots de données et de correction qui arrivent et qui les compare aux mots correspondants déjà reçus ce qui donne d'autres indications quant aux mots de données et de corrections faux, caractérisé par un circuit (183) raccordé au processeur (102) qui assigne des marques de bloc et de mot aux mots de données permettant de les identifier comme vrais ou faux afin d'assister les opérations d'interprétation, qui contient une mémoire pour les marques de bloc (103) et une mémoire pour les marques de mots (104) raccordé à sa sortie, dont le contenu est modifiable indépendamment l'un de l'autre afin que pour l'opération d'interprétation ayant lieu dans la seconde étape les marques de mots dans la mémoire (104) qui indiquent des mots déjà corrigés comme le mot commun aux deux groupes peuvent être modifiés afin de permettre des opérations d'interprétation suivantes, dans une seconde étape, avec des marques adaptées.

13. Appareil selon la revendication 12, caractérisé par un générateur (122) qui indique l'état des groupes à examiner raccordé à la mémoire (104) et au processeur (101) qui établit et interprète les mots de correction (13 à 16).

14. Appareil selon la revendication 13, caractérisé par une unité de contrôle (124) qui contribue à corriger les erreurs d'enregistrement et de lecture de durée limitée et qui produit des marques de blocs et de mots ainsi que des signaux de commande en fonction de signaux sortant du générateur (122) et de la mémoire (104) et par un détecteur d'erreurs d'enregistrement et générateur de signaux de surécriture (125) qui émet un signal de surécriture et des signaux de commande pour des marques de mots en fonction de signaux du générateur (122).

15. Appareil selon la revendication 12, caractérisé par un détecteur et générateur de signaux de diminution d'intensité (126) qui émet un signal de diminution d'intensité progressive en fonction de marques sortant de la mémoire (104).

16. Appareil selon la revendication 13, caractérisé en ce que le générateur (122) est conçu pour émettre un signal de sortie en fonction des erreurs dans les groupes P et Q, et en ce qu'il est muni d'autres entrées (130, 230) recevant d'autres informations ou le propre signal de sortie afin d'émettre le signal de sortie.

17. Appareil selon la revendication 14 ou 15, caractérisé en ce que le générateur (122) est conçu de telle manière que ses signaux de sortie destinés à l'unité de contrôle (124) se composent d'un premier signal (ZKA) indiquant un groupe de mots Q ou P non corrigibles et d'un second signal (EZP) qui indique des mots de données ou de correction dans un groupe P ou Q qui ne vont pas ensemble, et en ce que les signaux sortant du générateur (122) et destinés au détecteur et générateur (125) se composent du premier et du second signal (ZKA, EZP) et d'un autre signal (CRC) qui correspond à la marque de blocs originale.

18. Appareil selon la revendication 15, caractérisé en ce que le détecteur et générateur (126) se compose d'un circuit d'addition de comparaison et de sélection (178) travaillant en série et d'un générateur de seuils (188) et d'une mémoire de compteur (179) raccordés et travaillant en multiplexe de temps et en ce que le circuit (178) et la mémoire (179) forment ensemble un premier et un second compteur et en ce que l'entrée du circuit (178) est raccordée par une conduite (121, 127) à la mémoire (104), par un bus (187) au générateur de seuils (188) et par une conduite (180) à la mémoire (179) et en ce qu'un signal causant la diminution progressive de l'intensité des mots de données venant d'une part et simultanément l'augmentation progressive de l'intensité des mots de données venant d'autre part ainsi que des ordres d'enregistrement sont émis pour la mémoire (179) par des sorties (135, 186).

## EP 0 168 793 B1

**Claims**

1. Method for decoding a first sequence of digital data words (1 to 12) and correction words (13 to 16) having a first ordering and whereas the data words and correction words of this first sequence are newly combined to form a second sequence of digital data words and correction words having a second ordering, whereas the first sequence is divided into blocs (19), each bloc comprising a given number of data words and correction words in the first ordering and whereas a first group of words ($Q_0$) and a second group of words ($P_0$) comprising data words and correction words is formed, characterized in that the first and second group of words ($Q_0$, $P_0$) are formed in such a way as to have one word (1) in common, in that this common word is the first word of a bloc (19) in the first sequence, in that the data words and the correction words of the first and second word groups in a first step are submitted to a checking operation where the existance of at least one erroneous word in both groups is revealed but where the erroneous words are not identified, in that, in a second step the results of the checking operation on the data words and correction words of the first and second group are evaluated, whereas it can be decided if the common word is erroneous or errorfree and in that it is decided if erroneous words can be corrected or not and whereas correctable erroneous words are corrected using correction words, if it is permitted as a result of the evaluation.

2. Method according to claim 1, characterized in that a third word group ($Q_1$) and a fourth word group ($P_1$) are formed from the second sequence, in that the third word group shares one common word with the second word group ($P_0$) and with the fourth word group ($P_1$), in that the first data word of the fourth word group ($P_1$) and the last data word of the second word group ($P_0$) are shared with the third word group ($Q_1$) and in that the third and fourth word groups ($Q_1$ and $P_1$) are together submitted in a third step to checking operations and in a fourth step to an evaluation.

3. Method according to claim 1, characterized in that a block error detection code (17) is added to each block (19) of the first sequence, that said block (19) is submitted to a checking operation of the block error detection code, that a block flag indicating that the block is erroneous or error free is issued for the block (19) as a result of the checking operation, that depending on the block flag each data word and correction word of this block is provided with a word flag indicating if the word is erroneous or errorfree that a separate channel is provided for processing data words, correction words, block flags and word flags and in that word flags are associated with data and correction words in a word group at a moment preceding the checking operations executed on a preceding word group ($Q_0$) in order to have the possibilty to modify block flags after having processed a first data word (1) and prior to processing of the remaining data and correction words (2 to 16) of the block (19) taking into account all errors.

4. Method according to claim 2, characterized in that a word flag is associated to each data and correction word, indicating if said word is erroneous or errorfree in that the word flag of an erroneous data or correction word of the third word group ($Q_1$) is used for determining the data or correction word which also belongs to a fourth word group ($P_1$) which is submitted to a evaluating operation.

5. Method according to claim 3 or 4, whereas a block error detection code (17) is associated to each block (19), characterized in that error signals are generated depending on the block error detection code and on evaluation operations made on word groups ($Q_0$ to $P_1$) and in that control signals are generated depending on said error signals for controlling subsequent treatment of data words.

6. Method according to claim 5, characterized in that subsequent treatment consists of a crossfade of data words.

7. Method according to claim 5, characterized in that subsequent treatment consists of fading of data words.

8. Method according to claim 5, characterized in that subsequent treatment consists of emitting data words together with corresponding word flags.

9. Method according to claim 5, whereas blocks (19) are recorded on several tracks on a record medium, characterized in that error signals are produced for each track, in that the error signals of all tracks are used for generating an error pattern and in that a decision for producing control signals is taken depending on the error signals from a plurality of the tracks.

10. Method according to claim 7, characterized in that write addresses for writing a sequence of data words in the second ordering into a memory for coding and for reading of data words in a second ordering from a memory when decoding are offset with respect to time, in order to generate in time a fading signal for data words and in that word flags for, recombined data words are read out from a memory for word markers with help of said write addresses.

11. Method according to claim 7, characterised in that successive word flags indicating false words are continuously counted and compared to a first threshold value, in that a fading signal is generated, when said threshold value is met, in that pulses of an increment generator (188) are counted from the moment said threshold value is met and that the total of said counted pulses is continuously compared to a second threshold value and in that the fading signal is ended, when said second threshold value is met.

12. Apparatus for executing the method according to claim 1, comprising a memory (100) where data and correction words are written in a first ordering and from which they are read in a second ordering, comprising a computing unit (101) connected to the memory (100) and designed for executing checking and evaluating operations on first and second word groups formed in the memory (100), comprising a computing unit (102) for evaluating a block error check code, arranged in parallel to the memory (100) producing block error check code words based on incoming data and correction words and comparing them with existing block error check code words, thus providing additional indication related to erroneous data and correction words, characterized by an assignment circuit (183) connected to the computing unit (102) for evaluating a block error check code and assigning block flags and word flags to data words for assisting evaluation operations and for identifying erroneous and errorfree blocks and words and which comprisies a block flag memory (103) and a word flag memory (104) connected downstream whose content is independently modyfiable permitting to change word flags for already corrected words in the word flag memory (104) such as the common word during evaluation operations in the second step so that subsequent evaluation operations can be performed in the second step with adjusted word flags.

13. Apparatus according to claim 12, characterized by a check line state generator (122) connected to the word flag memory (104) and to the computing unit (101) computing and evaluating correction words (13 to 16).

14. Apparatus according to claim 13, characterized by a control circuit (124) for correcting short individual write and read errors, producing block flags, word flags and control signals based on output signals from the check line state generator (122) and the word flag memory (104) and by an error detector and crossfade generator (125) generating a crossfade signal and control signals for word flags based on signals coming from the check line state generator (122).

15. Apparatus according to claim 12, characterized by a read error detector and fading generator (126) producing a fading signal as a function of word flags from the word flag memory (104).

16. Apparatus according to claim 13, characterized in that the check line state generator (122) is designed for producing an output signal as a function of the error state in P-Q-word groups, in that the check line state generator (122) is provided with additional inputs (130, 230) and designed to produce output signals from error states otherwise captured or from its own output signal.

17. Apparatus according to claim 14 or 15, characterized in that the check line state generator (122) is designed to produce output signals for the control circuit (124) from a first signal (ZKA), related to a noncorrectable Q- or P-word group and from a second signal (EZP) related to data or correction words in a Q- or P-word group which do not belong together and in that the output signals of the check line state generator (122) for the write error detector and crossfade generator (125) are composed of the first and second signal (ZKA, EZP) and of another signal (CRC) corresponding to the original block flag.

18. Apparatus according to claim 15, characterized in that the read error detector and fading generator (126) is composed of a serially operating adding comparing and selecting circuit (178), of a generator (188) for threshold output value and increment connected thereto and of a counter state memory (179) operating in time multiplex whereas the adding circuit (178) and the counter state memory (179) together form a first and a second counter and whereas the adding comparing and selecting circuit (178) has lines (121, 127) connecting its input with the word flag memory (104) and a bus (187) and a line (180) connecting its input with the generator (188) and the counter state memory (179) and emits a crossfade signal as well as write instructions for the counter state memory (179) via outputs (135, 186).

Fig. 1

Fig. 2

Fig. 3

Fig. 4

Fig. 5

Fig. 7b

## Fig. 6

39
25
38 45 46 Q₁ 37
40
13
5
3
42
41
1
49
Q₀
50
43
P₀
44
47
P₁
48

## Fig. 7a

52 70 68 67 62   64 61   51   59   25
54
53
69 66 65
63
40
Q₁ P₁   Q₁ P₁   Q₁ P₁   Q₁ P₁

## Fig. 8

| | | | EZP = 0 | | | EZP = 1 | — 57 |
|---|---|---|---|---|---|---|---|
| | | | ZKA = 0 | | ZKA = 1 | ZKA = 0 | — 56 |
| 58 Q₀,₁  P₀,₁ | | | AWF SRW 0  0 | AWF SRW 1  X | AWF SRW >1  X | AWF SRW 0  1 | — 55 |
| EZP = 0 | ZKA = 0 | AWF 0 SRW 0 | | EWK | | MPZ | — 255 |
| | | AWF 1 SRW X | EWK | EWK | EWK | – | — 60 |
| | ZKA = 1 | AWF >1 SRW X | | EWK | | MPZ | |
| EZP = 1 | ZKA = 0 | AWF 0 SRW 1 | MPZ | MPZ | – MPZ | MKW MKW | — 256 / 71 |

57   56   55   255   256

2

Fig.9

EP 0 168 793 B1

Fig. 10a

- 137
- SPEICHERADRESSEN-TREIBER (155)
- 133
- EINTAKTSPEICHER (148), 152, 153, 154
- 151, 146, 147
- ADDIERER (150)
- 145
- ADRESS-GENERATOR (141)
- INSTRUKT. GENERATOR (143), 142
- 149, 140
- BLOCK-ZÄHLER (139)
- PROGRAMM-ZÄHLER (138), 191

4

Fig. 10b

Fig. 11

EP 0 168 793 B1

Fig. 12

Fig. 13